# EUROPEAN PATENT SPECIFICATION

(11) **EP 4 264 897 B1**
(45) Date of publication and mention of the grant of the patent: **08.07.2026**
(21) Application number: 21830479.8
(22) Date of filing: 13.12.2021
(51) Int. Cl.: H04L 27/14, H04B 1/30, H03D 3/00, H03D 7/16

(54) **APPARATUS AND METHOD FOR DOWNCONVERTING A RECEIVED FREQUENCY MODULATED COMMUNICATION SIGNAL**
APPAREIL ET PROCÉDÉ DE CONVERSION DESCENDANTE D'UN SIGNAL DE COMMUNICATION REÇU MODULÉ EN FRÉQUENCE
VORRICHTUNG UND VERFAHREN ZUR ABWÄRTSKONVERTIERUNG EINES EMPFANGENEN FREQUENZMODULIERTEN KOMMUNIKATIONSSIGNALS

(30) Priority: 16.12.2020 GB 202019870
(43) Date of publication of application: 25.10.2023
(73) Proprietor: Raptor Data Limited, Aberdeen Aberdeenshire AB15 4YL (GB)
(72) Inventor: MACLEAN, Colin Sinclair, Aberdeen, Aberdeenshire AB21 7BD (GB); BUDIARJO, Ibrahim, Aberdeen, Aberdeenshire AB10 6RG (GB)
(74) Representative: HGF
(86) International application number: PCT/GB2021/053263
(87) International publication number: WO 2022/129880

(56) References cited:
- US-A1- 2008 192 876
- LIU HANLI ET AL: "A DPLL-Centric Bluetooth Low-Energy Transceiver With a 2.3-mW Interference-Tolerant Hybrid-Loop Receiver in 65-nm CMOS", IEEE JOURNAL OF SOLID-STATE CIRCUITS, IEEE, USA, vol. 53, no. 12, 1 December 2018 (2018-12-01), pages 3672 - 3687, XP011701013, ISSN: 0018-9200, [retrieved on 20181218], DOI: 10.1109/JSSC.2018.2878822

## Description

### BACKGROUND

A borehole or well may be drilled in the earth's sub-surface in order to explore for or exploit underground resources such as underground oil, gas, shale or water. During such drilling it may be useful to acquire data from the borehole or well. For example, it may be useful to acquire data from drilling rig sensors to monitor and manage drilling operations, to record information relating to geological formations penetrated by the borehole, to generate operations statistics and performance benchmarks and to provide well planners with accurate historical operations performance data which can be referred to in future operations. Data may be communicated from sensors in the borehole or well to nodes closer to or at the surface. Such communications can be challenging to implement at the exploration site as they are typically remote (often offshore and hundreds or thousands of meters below sea level) and the environment can vary significantly in terms of the surrounding geological features and the thermal and mechanical properties of the materials present in an established well (such as the pipework (e.g. drill string, riser, etc.) and production tubing, casing, lining, mud, hydrocarbons (i.e. "product"), lubricants and seawater). Downhole conditions are also hostile with unstable, difficult communication conditions and high temperatures. The high temperature environment also restricts hardware computational resources to low speed processors with small amounts of on-board memory.

For "in-well" communications, the communications medium is often solid - for instance, a drill string, a casing or a riser. Communications technologies based on transmission and reception of electromagnetic waves suffer disadvantages in providing in-well and underwater communications. Therefore, for in-well and many underwater applications, it is more usual to adopt acoustic telemetry, fluid pulse telemetry (which typically uses fluid pulse signals comprising pressure pulses that propagate within a column of drilling fluid or product (e.g. oil) inside a drill string), such as mud pulse telemetry (using pressure pulses that propagate within the column of drilling fluid inside the drill string) or product pulse telemetry (using pressure pulses that propagate within the column of extracted oil/gas or other product inside the drill string), or other ultrasonic communications technologies. In acoustic telemetry, for instance, an encoded sound wave may be generated by a suitable transmitter. The sound wave may then propagate along the pipework, casing and/or production tubing. A receiver may then extract the data from the signal. The transmitter may be located "downhole", while the receiver may be placed at or near the well head, at the surface or vice versa. Any portion of the drilling operation below the site of a wellhead may be referred to as "downhole".

Due to the limited hardware computational resources available, it is advantageous to provide more efficient ways of processing received data.

US 2008/192876 A1 describes a variable delay digitally controlled crystal oscillator (DCXO) buffer.

LIU HANLIE ET AL: "A DPLL-Centric Bluetooth Low-Energy Transceiver With a 2.3-mW Interference-Tolerant Hybrid-Loop Receiver in 65-nm CMOS", IEEE JOURNAL OF SOLID-STATE CIRCUITYS, IEEE, USA, vol. 53, no. 12, pages 3672-3687, 1 December 2018 describes a Bluetooth low-energy (BLE) transceiver for Internet-of-Things (IoT) applications.

### SUMMARY

The extent of protection conferred is determined by the claims.

### BRIEF DESCRIPTION OF THE DRAWINGS

Examples are further described with reference to the accompanying drawings, in which:
Fig. 1 schematically illustrates a drill string extending along borehole between first and second communications nodes;
Fig. 2 schematically illustrates a communications node of Fig. 1;
Fig. 3a shows an example chirp signal in the time domain;
Fig. 3b shows a pulse compressed version of the chirp signal of Fig. 3a;
Fig. 4a is a block diagram of a first apparatus for downconverting a frequency modulated communication signal in the time domain;
Fig. 4b is a block diagram of a second apparatus for downconverting a frequency modulated communication signal in the time domain;
Fig. 5 illustrates part of the apparatus of Fig. 4b;
Fig. 6 is a spectrum of an example received, sampled frequency modulated communication signal having a pair of frequency bands;
Fig. 7 is the spectrum of Fig. 6 downconverted in accordance with a carrier frequency;
Fig. 8 is the spectrum of Fig. 7 without signals which are filtered out between lower and upper passbands;
Fig. 9 is a time domain representation of a received communication signal pre (bottom) and post (top) downconversion;
Fig 10 is a block diagram of apparatus for downconverting a received frequency modulated communication signal in the frequency domain;
Fig. 11 is a flow diagram illustrating a method of downconverting a received frequency modulated communication signal in the frequency domain;
Fig. 12 is a spectral diagram of example signals which may be frequency shifted in accordance with the method of Fig. 11;
Fig. 13 is the spectral diagram of Fig. 12 with signal frequencies in a target frequency band frequency shifted;
Fig. 14 is the block diagram of Fig. 10 further showing multiplication by frequency domain decoding, equalisation, windowing and filtering functions;
Fig. 15 shows a received frequency modulated communication signal which has been sampled, converted into the frequency domain and frequency shifted to provide first and second data in first and second frequency ranges and intermediate data in an intermediate frequency band extending between the first and second frequency ranges;
Fig. 16 shows a close-up view of the first frequency band of Fig. 15;
Fig. 17 shows the signal of Fig. 15 converted into the time domain;
Fig. 18 shows the signal of Fig. 15 with a reduced quantity of intermediate data;
Fig. 19 shows the signal of Fig. 18 converted into the time domain;
Fig. 20 shows digital frequency domain data having a first signal component at a target frequency band and a second signal component comprising a copy of the first signal component folded about half the sampling frequency;
Fig. 21 shows downconverted digital frequency domain data based on a first portion of the digital frequency domain data of Fig. 20 corresponding to the target frequency band;
Fig. 22 shows example digital frequency domain data having a first signal component at a target frequency band and a second signal component comprising a copy of the first signal component folded about half the sampling frequency;
Fig. 23 shows a close up view of the first signal component of Fig. 22;
Fig. 24 shows example digital frequency domain data based on a first portion of the first digital frequency domain data of Figs. 22, 23 corresponding to a target frequency band of the frequency modulated communication signal, the example digital frequency domain data having been processed in the frequency domain;
Fig. 25 shows a close-up of the portion of Fig. 24 near zero Hz;
Fig. 26 shows the absolute real (top), imaginary (middle) and complex (bottom) values of time domain data obtained by converting the frequency domain data of Fig. 25 into the time domain;
Fig. 27 shows downconverted digital frequency domain data corresponding to the data of Fig. 25 with the number of samples in the downconverted digital frequency domain data of Fig. 27 having been reduced by a factor of 16 relative to the first digital frequency domain data of Fig. 22;
Fig. 28 shows the absolute real (top), imaginary (middle) and complex (bottom) values of time domain data obtained by converting the frequency domain data of Fig. 27 into the time domain;
Fig. 29 is a flow diagram illustrating a method of downconverting a received frequency modulated communication signal in the frequency domain;
Fig. 30 illustrates a spectrum of real values of complex time domain data resulting from the conversion of downconverted digital frequency domain data to the time domain;
Fig. 31 illustrates a spectrum of imaginary values of the complex time domain data resulting from the conversion of the downconverted digital frequency domain data to the time domain;
Fig. 32 is a block diagram illustrating an example process for generating an unstored one of the real and imaginary parts of complex time domain data from a selectively stored one of the real and imaginary parts;
Fig. 33 illustrates outputs of the FFT block of Fig. 32;
Fig. 34 is a close-up view of the top waveform of Fig. 28, which shows the absolute real values of time domain data obtained by converting the downconverted digital frequency domain data of Fig. 27 into the time domain;
Fig. 35 shows the output of the FFT block of Fig. 32 when the input to the FFT block is the signal of Fig. 34;
Fig. 36 shows the output of the low pass filter of Fig. 32 when the input to the low pass filter is the signal of Fig. 35;
Fig. 37 (upper) shows the absolute values of the imaginary part of time domain data generated based on the real time domain data of Fig. 34 using the process of Fig. 32;

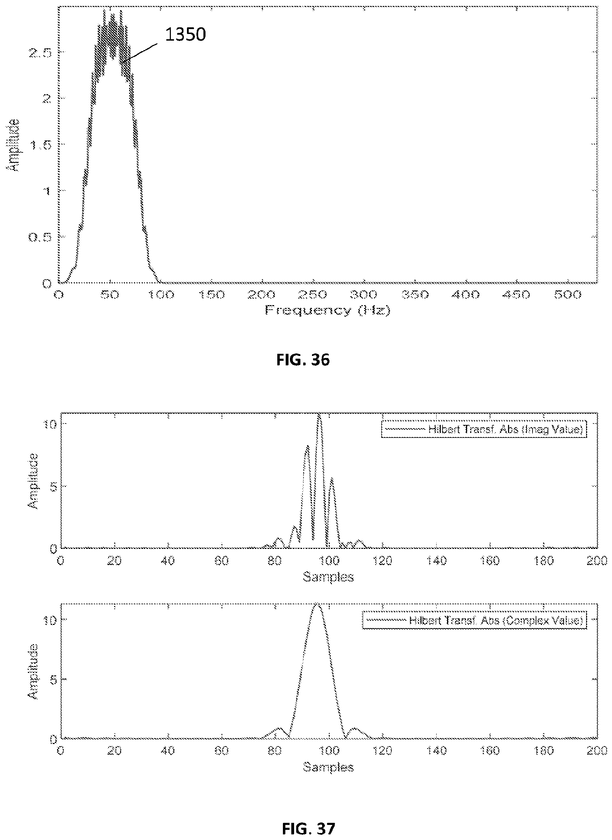

Fig. 37 (lower) shows the absolute complex values of the time domain data taking into account the generated imaginary part of the time domain data of Fig. 37 (upper); and

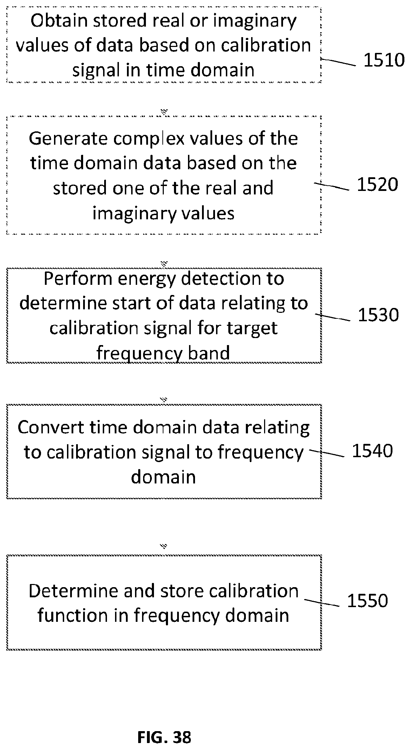

Fig. 38 is a flow diagram illustrating a method of generating a calibration function for equalising the effects of the communication channel on a payload data signal.

### DETAILED DESCRIPTION

An apparatus, method and communications node are described below for processing (e.g. downconverting) a frequency modulated signal. Also disclosed are computer program products and non-transitory computer readable media.

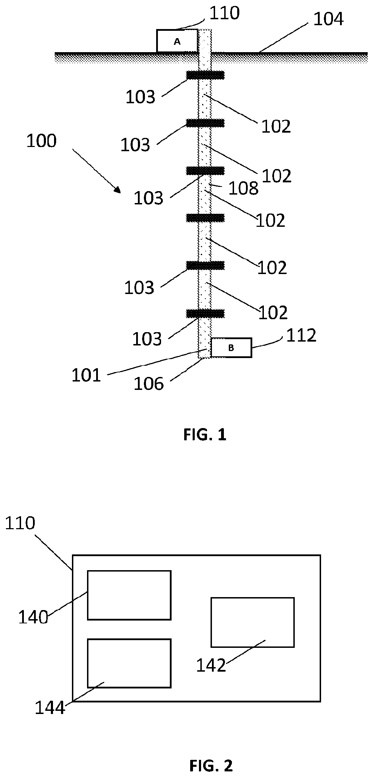

Fig. 1 shows a drilling rig having a drill string 100 extending longitudinally down a borehole 108, the drill string 100 comprising a drill bit 101 at a downhole longitudinal extent thereof and plurality of solid, hollow, tubular drill string sections 102 connected to each other longitudinally by couplings 103 and to the drill bit 101, the drill string 100 extending between a surface 104 and a lower longitudinal extent 106 of the borehole (or wellbore) 108, the borehole 108 being drilled by the drill bit 101. Downhole equipment (not shown) may be provided down the borehole 108, such as any one or more of: sensors, such as temperature sensors or pressure gauges; valves; chokes; firing heads; packers; perforators; samplers; flow meters; fluid analysers. The surface 104 may be a land surface or a surface of a sea bed, for example. The drill string sections 102 each have bores defined by solid, tubular walls and the sections 102 may be coupled together such that their bores are in fluid communication with each other and, typically, such that fluid tight seals are provided at the joints between sections 102. Drilling fluid may be transmitted through the bores of the tubular sections 102 from the surface 104 to the drill bit 101 and circulated back up to the surface 104 through an annular gap between the tubular drill string sections 102 and the side walls of the borehole 108. Torque may be applied to the drill bit 101 by way of torque applied to the tubular sections 102 of the drill string 100, for example by a top drive (not shown). A first communications node 110 may be provided at the surface 104 and a second communications node 112 may be provided at the lower longitudinal extent 106 of the borehole 108. The second node 112 may be communicatively coupled to the downhole equipment. It will be understood that the first communications node 110 may alternatively be provided beneath the surface 104, while the second communications node 112 may be provided above the lower extent 106 of the borehole 108. The first communications node 110 may be provided vertically closer to the surface 104 than the second communications node 112 is to the surface 104. The first and second nodes 110, 112 may be mechanically connected to the drill string 100, for example by way of respective couplers. The drill string 100 may be connected to a wellhead (not shown) at the surface 104. In this case, the wellhead may comprise the first communications node 110, although it will be understood that the first communication node 110 may alternatively be provided for example on the top drive, above or below slips supporting the drill string 100 below the top drive, or as part of the drilling rig.

Data, such as telemetry data or command or control data, may be communicated between the first and second nodes 110, 112 by way of a communications channel. For example, command or control data may be transmitted from the first node 110 to the second node 112, for example to control or modify the operation of downhole equipment (e.g. a test valve) or request sensor data from downhole monitoring equipment. In this case, it may be that the second node 112 is communicatively coupled to the said downhole equipment, and may be configured to forward command or control data received from the first node 110 to the downhole equipment. In another example, command acknowledgement or monitoring data such as sensor data from downhole equipment may be transmitted from the second node 112 to the first node 110. Again in this case, it may be that the second node 112 is communicatively coupled to the downhole equipment such that the second node 112 can receive the command acknowledgement or monitoring data from the downhole equipment and forward it to the first node 110.

It may be that the communication channel has a dynamically variable transfer function. It may be that one or more frequency band(s) which are open for data communication by way of the communication channel change dynamically over time. It may be that the communication channel is noisy, lossy or noisy and lossy. It will be assumed in the following discussion, by way of example, that data is communicated between the first and second communications nodes 110, 112 by way of acoustic signals. It may be that the acoustic signals are transmitted and received through the solid longitudinal walls of the drill string sections 102 extending from the surface 104 to the lower longitudinal extent 106 of the borehole 108, the solid longitudinal walls of the drill string sections 102 acting as a communication channel by way of which data is communicated acoustically. However, it will be understood that data additionally or alternatively may be communicated between the first and second communications nodes 110, 112 by any other suitable way such as electromagnetically or by way of pressure pulses in fluid flowing through the drill string 100, or through the annular gap between the drill string 100 and the side walls of the borehole 108, such as mud, drilling fluid or product from the borehole 108, such as oil or water, or any combination thereof. Thus, the communication channel may comprise or consist of any matter extending or flowing between the first and second communications nodes 110, 112, such as solid matter or fluid propagating between the first and second communications nodes 110, 112. It may be that the communication channel comprises a communications medium, such as an acoustic communications medium. It may be that the communications medium is a wireless communications medium. An additional or alternative acoustic communication channel to the drill string 100 may be provided for example by coiled tubing or production tubing which may extend between the first and second communications nodes 110, 112. It may be that the communication channel is a downhole, "in well" or underwater communication channel. It may be that the communication channel comprises a solid communication channel such as any one or more of a drill string, a casing, production tubing, a riser, coiled tubing extending between the first and second nodes 110, 112, or a fluid communication channel such as mud, product or any combination thereof propagating between the first and second nodes 110, 112. The transceivers (see below) of nodes 110, 112 may be selected according to the selected communications medium (e.g. the transceivers may be electromagnetic or acoustic transceivers for example).

The drill string 100 may have a periodic structure which causes it to act as a mechanical filter, trapping (i.e. damping) signals having frequencies that lie within certain bands. The filtered nulls, where frequencies do not propagate, are called stopbands; the frequencies where signals may be allowed to propagate are called passbands. The stopbands may be caused by joints or couplers 103 provided between adjacent longitudinal sections thereof. Additional factors may affect the transmission path and attenuation (energy loss) of a signal propagating along the drill string, such as tension or compression of the drill string sections 102, contact of the drill string sections 102 with the side walls of the borehole 108, drilling fluid density passing through the drill string and mode coupling. Within these passbands there may be a number of instabilities. Their exact position and width vary from well to well, and can also vary dynamically during communications. The passbands may have a ripple (or 'fine structure'). The number of drill string sections 102 that the transmission energy has to pass through may primarily determine the number of ripples. The ripples may also vary over time with the changes in the depth and deviation of the well. Certain passbands may have more noise in them than others at any given time. The noise in particular passbands may reduce or the attenuation may change thus providing an increase in usable bandwidth. The frequency of a "passband", where communication is more effective, may vary over time.

It will be understood that other types of communication channel, such as other types of acoustic communication channel, may have different passbands and stop bands from a drill string. For example, coiled tubing may be considered to be acoustically joint-less for long distances, despite welds such as helical welds, which may they may have. Coiled tubing may thus provide broader frequency passbands in its acoustic frequency response than a drill string. In another example, it may be that production tubing is a more suitable acoustic communication channel at higher acoustic frequencies than a drill string, with a different arrangement of passbands and stop bands. Candidate passbands of the communication channel can be determined empirically.

Fig. 2 schematically illustrates apparatus of the first communications node 110. The second communications node 112 may have apparatus comprising the same or similar features. Indeed, it will be assumed in the following discussion that the second communications node 112 has apparatus comprising the same features as those shown in Fig. 2. As such, the second communications node 112 will not be described separately here.

The first communications node 110 may comprise processing circuitry 140 and a transceiver 142 communicatively coupled to the processing circuitry 140, for example by wired connections. The first communications node 110 may further comprise a memory 144 communicatively coupled to the processing circuitry 140. The processing circuitry 140 may be configured to generate communication signals to be transmitted by the transceiver 142.

The processing circuitry 140 may be configured to cause the transceiver 142 to transmit communication signals. The processing circuitry 140 may be configured to process communication signals received by the transceiver 142. The processing circuitry 140 may comprise general purpose processing circuitry or special purpose processing circuitry. The functionality of the processing circuitry 140 described herein may be implemented in software, hardware or firmware or a combination of any of software, hardware and firmware. For example, the processing circuitry 140 may be configured to retrieve and execute computer program instructions stored in the memory 144 to thereby provide its functionality described herein. The memory 144 may comprise any suitable memory such as cache memory, random access memory (RAM), read only memory (ROM), flash memory, magnetic or optical disk or any combination thereof. The transceiver 142 may be configured to transmit and receive acoustic signals, for example by way of an acoustic communication channel such as the drill string 100. The transceiver 142 may be operable to transmit and receive signals over a plurality of frequency bands. The transceiver 142 may be communicatively coupled to the communication channel by one or more couplers. The transceiver 142 may comprise one or more transducers, such as one or more acoustic transducers, which may be operable over a plurality of frequency bands. The transceiver 142 may comprise a discrete transmitter and a discrete receiver, which may each comprise a respective transducer such as a respective acoustic transducer, or the transceiver 142 may comprise an integrated transmitter and receiver which share hardware. For example, the transceiver may comprise an integrated transceiver and receiver which share a transducer such as an acoustic transducer. It may be that the transceiver is an acoustic, electromagnetic or fluid (e.g. mud or product) pulse transceiver configured to transmit and receive acoustic, electromagnetic or fluid pulse signals respectively. However, it will be assumed below that the transceiver is an acoustic transceiver. It may be that the transducer(s) are capable of converting acoustic signals to electrical signals, electrical signals to acoustic signals or both. It may be that the processing circuitry is configured to cause transmission of acoustic signals by the node by providing electrical signals to the transceiver for conversion to acoustic signals. It may be that the node is configured to receive acoustic signals by the transceiver converting received acoustic signals to electrical signals and passing the electrical signals to the processing circuitry 100.

As discussed above, the communication channel between the communications nodes 110, 112 may be noisy, lossy and dynamically changing. In order to account for the dynamically changing transfer function of the communication channel, calibration signals may be transmitted in addition to payload data signals between the first and second nodes 110, 112, the calibration signals occupying the same frequency band as the corresponding data signals. The receiving node may derive a calibration function from the received calibration signal, the calibration function being indicative of the effect of the communication channel on the calibration signal. The receiving node may then process the corresponding received payload data signal in dependence on the calibration function to equalise the effects of the communication channel on the payload data signal.

In order to provide the calibration and data signals with greater immunity to the noise levels of the channel, it may be that the calibration and data signals depend on (e.g. are encoded, for example by the processing circuitry of the transmitting node, in dependence on) respective codes. For example it may be that the calibration signal comprises calibration data encoded based on a respective code. The calibration data may comprise a constant or time varying amplitude. The calibration data may be known by the receiving node, for example by being stored at memory 144 of the receiving node. It may be that the payload data comprises a bit sequence for communicating information between the nodes 110, 112. For example it may be that the payload data signal comprises a bit sequence encoded based on a respective code. It may be that the payload data signal (and the calibration signal, where provided) is (are each) transmitted as a frequency modulated communication signal. It may be that the codes are time variant codes. It may be that the codes are spread spectrum codes such as any of: chirp codes; linear chirp codes; non-linear chirp codes; direct sequence spread spectrum codes; frequency hopping spread spectrum sequences. It may be that the respective codes are known to the receiving node, for example by being stored at memory 144 thereof.

It may be that the processing circuitry of the transmitting node is to encode the calibration signals, the data signals or the calibration and data signals at baseband. It may be that the transmitting node is configured to upconvert the (for example encoded) calibration signals, the data signals or the calibration and data signals, for example by a carrier frequency, to a transmission frequency band of the communication channel.

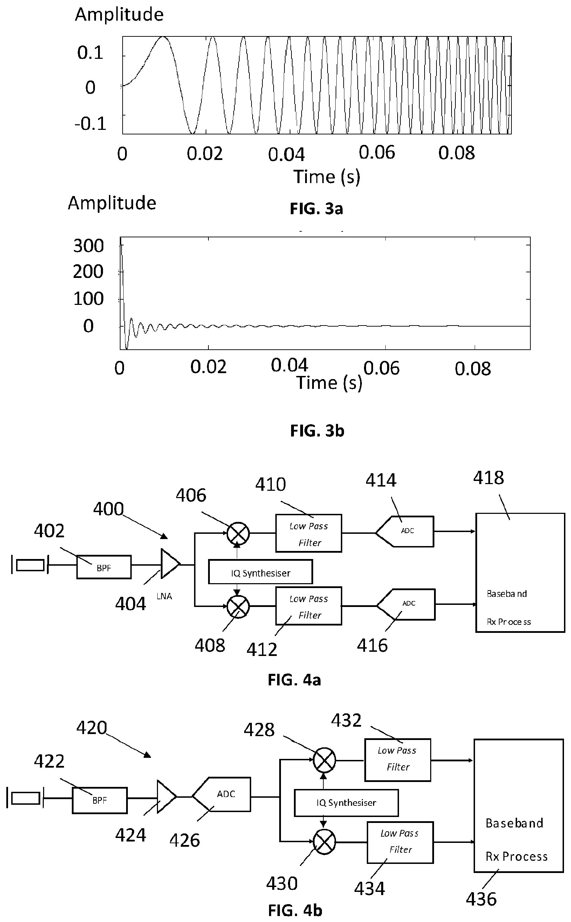

In an example, chirp codes may be used to provide a high signal to noise ratio to thereby allow data to be successfully transmitted through a downhole environment. A typical chirp pulse is a frequency sweep pulse with a short autocorrelation function. Chirp pulses may be any signal, such as a pressure wave signal, capable of pulse compression. An example chirp pulse of constant AC amplitude and varying frequency is illustrated in the time domain in Fig. 3a. A pulse compressed version of the chirp pulse of Fig. 3a, obtained by correlating the chirp function of Fig. 3a with a reference chirp identical to the chirp function of Fig. 3a, is shown in Fig. 3b, the pulse compressed version having an initial peak followed by lower amplitude oscillations.

Calibration signals may be transmitted before, after or overlapping in time with the data signals. When the calibration signals overlap in time with the data signals, the calibration and data signals may be encoded based on different codes to allow them to be discriminated with each other. For example, the calibration and data signals may be encoded based on codes which are orthogonal or pseudo-orthogonal to each other to allow the calibration and data signals to be discriminated from each other at the receiving node (e.g. it being that the calibration signal and the frequency modulated communication signal at least overlap with each other in the frequency and time domains). This is particularly beneficial during dynamic deployments such as drilling, where the transfer function of the communication channel may be quickly varying, as it can be better ensured that the communication channel has the same transfer function for both the calibration and data signals.

It may be that the calibration function is derived by the receiving node decoding the received calibration signal (e.g. correlating the received calibration signal with a known code by which the calibration data is encoded stored in and retrieved from the memory 144 of the receiving node) and taking the reciprocal of the magnitude and the complex conjugate of the phase of a frequency domain representation of the decoded calibration signal. In this case, the processing circuitry of the receiving node may further decode the payload data signal, for example based on (e.g. correlation with) one or more known codes by which the payload data signal is encoded stored in and retrieved from the memory 144 of the receiving node, before processing the decoded payload data signal depending on the calibration signal to equalise the effect of the communication channel thereon.

Alternatively, the calibration signal may depend on a code in common with the corresponding payload data signal, and it may be that the processing circuitry 140 of the receiving node processes the received calibration signal to determine the calibration function such that the calibration function depends on the common code by way of the dependency of the calibration signal thereon. It may be that the processing circuitry 140 of the receiving node processes the calibration signal to determine the calibration function without removing the dependency of the received calibration signal on the common code, such that the calibration function depends on the code by way of the dependency of the calibration signal thereon. As the calibration signal has propagated over the communication channel, the calibration function obtained in this way also depends on the transfer function of the communication channel. It may be that the calibration function is provided with information for decoding the payload data signal, such as information concerning the common code, by way of the calibration signal. It may be that the calibration function is implicitly provided with information concerning the common code for decoding the payload data signal by way of the calibration signal. The calibration function may be implicitly provided with the said information in the sense that the common code is not explicitly determined from the calibration signal, but that information concerning the common code is contained within the calibration function derived therefrom. Thus, the payload data signal can be decoded without prior knowledge of the common code by processing the frequency modulated communication signal depending on the calibration function.

It may be that the calibration function depends on a convolution of the calibration signal, which is dependent on the common code, with the transfer function of the communication channel. The processing circuitry 140 of the receiving node may process the respective received payload data signal, without first removing the dependency of the respective payload data signal on the common code (e.g. without first decoding the payload data signal), depending on the corresponding calibration function. In this way, the payload data signal may be both decoded and have the effects of the communication channel thereon equalised by processing it depending on the calibration function.

The calibration signal may comprise or consist of a plurality of first signal frequencies within the frequency band. The calibration signal frequencies may span at least 70%, at least 80%, at least 90%, at least 95% or 100% of the respective frequency band. For example, the calibration signal may comprise a chirp signal such as an up-chirp or down-chirp which sweeps at least 70%, at least 80%, at least 90%, at least 95% or 100% of the respective frequency band.

It may be that the frequency bands are narrowband frequency bands. It may be that the widths of the frequency bands depend on the implementation, for example on the type of communication channel. For example, it may be that a coiled tubing communication channel provides wider frequency bands than a drill string. It may be that, for each of the frequency bands, the difference between the lower and upper frequency cut-offs of the frequency band may be between 10Hz and 5000Hz, 10Hz and 3000Hz, 10Hz and 1000Hz, 10Hz and 500Hz, 10Hz and 250Hz, 50Hz and 150Hz, 100Hz or substantially 100Hz, 2kHz or substantially 2kHz or at least 2kHz. The frequency bands may have bandwidths of less than half of the sampling frequency. The frequency bands may be assumed to be provided at (e.g. substantially) fixed frequencies.

It will be assumed in the discussion below that the calibration and data signals are encoded by way of the same chirp code (e.g. a chirp code in common with each other). However, it will be understood that the calibration and data signals may alternatively be encoded by different (e.g. orthogonal or pseudo-orthogonal) chirp signals. It will also be understood that the calibration and data signals may alternatively be encoded by different types of codes such as codes based on quadrature phase shift keying (QPSK), quadrature amplitude modulation (QAM) or orthogonal frequency division multiplexing (OFDM).

Figures 4a and 4b are block diagrams of apparatus 400, 420 for downconverting a frequency modulated signal such as an encoded payload data signal in the time domain. In the apparatus 400 of Fig. 4a, the received frequency modulated communication signal is processed by a band pass image rejection filter 402 having a frequency pass band which includes the frequency band of the frequency modulated communication signal, before being processed by an analogue low noise amplifier 404. Next, the filtered, amplified signal is processed by a quadrature downconverter comprising parallel mixers 406, 408 in which a first copy of the filtered, amplified signal is mixed with a first local oscillator signal at a carrier frequency and a second copy of the filtered, amplified signal is mixed with a second local oscillator signal, the second local oscillator signal being the first local oscillator signal phase shifted by 90°. Where the frequency modulated communication signal is encoded depending on a chirp code such as a linear chirp code, the carrier frequency f_{c} may be equal to a mid-point frequency of the chirp code. The respective mixed signals are then processed by parallel low pass filters 410, 412, the low pass filters suppressing high frequency content associated with the spectrum centred around twice the carrier frequency. The outputs of the low pass filters 410, 412 provide I and Q waveforms which are then converted to the digital domain by parallel analogue to digital converters, ADCs 414 and 416 and passed to digital baseband processing circuitry 418 for further processing.

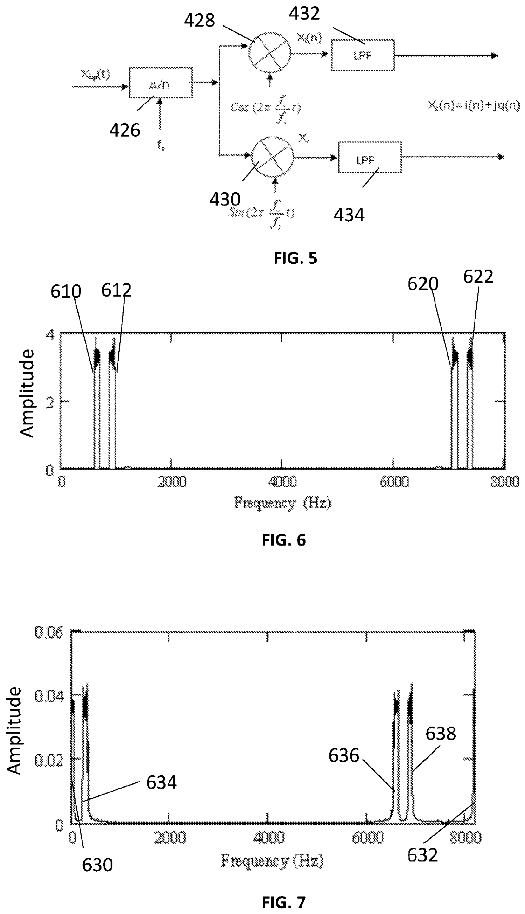

In the apparatus 420 of Fig. 4b, the received frequency modulated communication signal is processed by a band pass anti-aliasing filter 422 having a frequency pass band which includes the frequency band of the frequency modulated communication signal, before being processed by an analogue low noise amplifier 424. The output of the low noise amplifier 424 is processed by an analogue to digital converter, ADC, 426. Quadrature downconversion may then be performed digitally rather than in the analogue domain. Downconversion may be performed by parallel mixers 428, 430 respectively mixing copies of the filtered, digitised amplified received frequency modulated communication signal with "Sin(2π(fc/fs)t)", where fc is the carrier frequency, fs is the sampling frequency of the ADC 426 and t is time, and "Cos(2π(fc/fs)t)" respectively, where fc, fs and t are as before, the sine and cosine signals being digitally generated. Alternatively, a single copy of the filtered, digitised amplified received frequency modulated communication signal may be mixed with a complex exponential e^{j2π(fc/fs)t} to achieve the same result. As above, where the frequency modulated communication signal is encoded depending on a chirp code such as a linear chirp code, the carrier frequency f_{c} may be equal to a mid-point frequency of the chirp code. The outputs of the multiplications may be low pass filtered by parallel digital low pass filters 432, 434 of the respective branches comprising the mixers 428, 430 to thereby remove out of band copies and provide I and Q waveforms which are then passed to digital baseband processing circuitry 436 for further processing. This is illustrated in more detail in Fig. 5 which shows that the I and Q signals are combined in accordance with x(n)=i(n) + jq(n), where i(n) is the digital I signal and q(n) is the digital Q signal.

The downconversion by the downconverters of Fig. 4a or Figs. 4b, 5 may be repeated for each of a plurality of frequency bands in which payload data signals (and typically corresponding calibration signals) are received.

By way of example, with reference to Fig. 6, a communication channel having two passbands at 600-700Hz and 862-970Hz may be considered. However, it will be understood that any suitable passbands and any number of passbands may be provided. It will be assumed below that the frequency modulated communication signal comprises a payload data signal. Calibration signals will not be considered in detail in this example for brevity but it will be understood that corresponding calibration signals may be transmitted and received in the respective bands to determine respective calibration functions, for example by which effects of the communication channel may be equalised in the data signal.

In this example, a frequency modulated communication signal comprising a first communication signal component 610 encoded by a chirp code having a frequency which sweeps between 600Hz and 700Hz and a second communication signal component 612 encoded by a chirp code having a frequency which sweeps between 862Hz and 970Hz is received from a first of the nodes 110, 112 by the receiver of the second of the nodes 110, 112. The receiving node 110, 112 may comprise a downconverter in accordance with Fig. 4b and 5. Although the signal components are processed in the time domain by the downconverter of Fig. 4b, 5, Fig. 6 shows the frequency domain spectra of the first and second communication signals 610, 612 output by the ADC 426 following bandpass filtering and low noise amplification. It will be assumed that the received frequency modulated communication signal is sampled at a sampling frequency of 8kHz by the ADC 426, but it will be understood that any suitable sampling frequency may alternatively be employed. Also shown in Fig. 6 are aliased copies 622, 620 of the first and second communication signal components 610, 612 folded around half the sampling frequency of the ADC 426 (i.e. folded around 4kHz). Signal component 622 in the band 7300-7400Hz is a folded copy of the first signal component 610 in the 600-700Hz frequency band, while signal component 620 in the band 7030-7138Hz is a folded copy of the second signal component 612 in the 862-970Hz frequency band. Data at frequency f of the signal components 610, 612 in the 600-700Hz and 862-970Hz bands corresponds to data at frequency fs-f in the folded copies 622, 620, where fs is the sampling frequency of the ADC 426. That is, folded copies 622, 620 are copies of the signal components 610, 612 folded around half the sampling frequency (in this case 4kHz).

As discussed above, the 600-700Hz signal component 610 may be downconverted by parallel mixers 428, 430 mixing a first amplified, digitised and filtered copy of the received frequency modulated communication signal 610, 612, 620, 622 with Sin(2π(fc/fs)t) and mixing a second amplified, digitised and filtered copy of the received frequency modulated communication signal 610, 612, 620, 622 with Cos(2π(fc/fs)t), where fc is 650Hz (i.e. the mid-point frequency of the 600-700Hz frequency band) and fs is 8kHz. Alternatively, as discussed, a single copy of the 600-700Hz signal may be mixed with a complex exponential signal e^{j2π(fc/fs)t} to achieve the same result. The outputs of the mixers are then low pass filtered by filters 432 and 434 and combined to provide an output x(n) = i(n) + jq(n), where i(n) is the output of the I-branch low pass filter 432 and q(n) is the output of the Q-branch low pass filter 434. A frequency domain spectrum of x(n) is shown in Fig. 7, although in practice the signals remain in the time domain as discussed above.

The downconversion of the first communication signal component 610 maps the frequencies 600Hz-700Hz of the first communication signal component 610 to frequencies -50Hz to +50Hz. The portion of the first communication signal component 610 having frequencies 650Hz-700Hz is mapped to a first output signal component 630 of Fig. 7 having frequencies from 0-50Hz. The downconverted signal is replicated at integer multiples of the sampling frequency fs (which is 8kHz in this case). Accordingly, the portion of the first communication signal 610 having frequencies 600Hz-650Hz appears at a second output signal component of Fig. 7 having frequencies from 7950Hz - 8000Hz. Thus, the components 630 and 632 of Fig. 7 at 0-50Hz and 7950-8000Hz together contain all of the information from the first communication component 610 received by the node shown in Fig. 6.

Fig. 7 also shows additional signal components which result from the downconversion of the signal of Fig. 6. These include: a third signal component 634 having frequencies from 212-320Hz; a fourth signal component 636 having frequencies between 6380-6488Hz; and a fifth signal component 638 having frequencies between 6650-6750Hz. The third signal component 634 is generated by way of the downconversion of the second communication signal component 612 of Fig. 6 by the carrier frequency fc. The fourth signal component 636 is generated by way of the downconversion of the folded copy 620 of the second communication signal component 612 at 7030-7138Hz. The fifth signal component 638 is generated by way of the downconversion of the folded copy 622 of the first communication signal component 610 at 7300-7400Hz. In practice these signal components are filtered out by the low pass filters 432, 434 which may have low-pass cut-off frequencies of half the bandwidth of the signal being downconverted (in this case the bandwidth of the 600-700Hz frequency band is 100Hz, so the cut-off frequency of the low-pass filter may be 50Hz). It will be understood that the passbands of the low-pass filters 432, 434 also fold about the sampling frequency fs, such that they pass the component 632 of the output signal of Fig. 7 from 7950Hz-8000Hz.

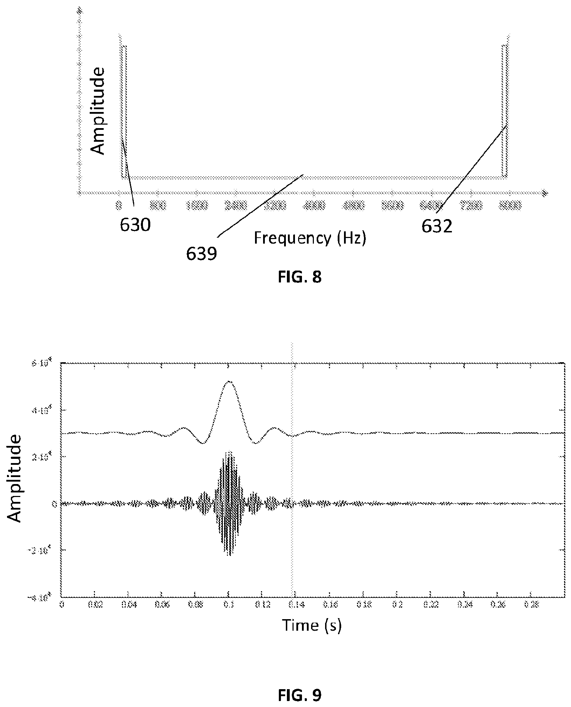

With the signal components 634, 636, 638 filtered out, the signal of Fig. 8 is provided which consists of the first signal component 630 at a first frequency band 0-50Hz, the second signal component 632 at a second frequency band 7950-8000Hz and intermediate data 639 between the first and second frequency ranges, wherein the first and second frequency ranges together contain the downconverted signal information and the intermediate data substantially comprises null data. By way of the filtering, signals relating to the second signal component 612 at 862-970Hz have been removed, as have extraneous copies of the first signal component 610.

A similar process may be performed for downconversion of the signal in the 862-970Hz band. However, for brevity, downconversion of the signal in this band will not be described separately here.

Fig. 9 shows, in the time domain, an example first communication signal prior to downconversion (bottom) and after downconversion (top with an arbitrary DC offset applied for illustration purposes). The downconverted signal comprises the envelope of the pre-downconverted signal, the carrier having been removed therefrom by the downconversion.

The downconverted signals may be further processed by baseband processing circuitry. Processing may involve equalising the effects of the communication channel on the data signal by convolving the downconverted data signal with a calibration function derived from a received calibration signal. It may be that the calibration function is derived from the calibration signal by: downconverting the calibration signal; and determining a calibration function from the downconverted calibration signal. Additionally or alternatively, processing may involve correlating the downconverted data signal with a reference signal by which the downconverted data signal may be decoded (e.g. pulse compressed). In this case, it may be that the reference signal comprises the code on which the frequency modulated communication signal is based. As discussed above, decoding may be performed together with equalisation if the calibration function is dependent on a common code by which the calibration and data signals are encoded. Additionally or alternatively, processing may involve windowing the downconverted data signal in order to minimise or reduce intersymbol interference with data in neighbouring bands.

Convolution and correlation in the time domain are computationally expensive operations. In downhole environments, where processing capacity and computing resources are limited, it would be beneficial to reduce computational requirements. Convolution of two signals in the time domain is equivalent to multiplication of those signals in the frequency domain. Similarly, correlation of two signals in the time domain is equivalent to multiplication by the complex conjugate in the frequency domain. Multiplication in the frequency domain is less computationally expensive than correlation or convolution in the time domain. There is thus a benefit, particularly in downhole applications, to performing the above-mentioned correlation and convolution operations by way of multiplication in the frequency domain. However, this benefit is mitigated by the fact that conversion of the received signals from the time domain to the frequency domain and back to the time domain, for example by using the fast Fourier transform, FFT, and the inverse Fast Fourier Transform, iFFT, is also computationally expensive.

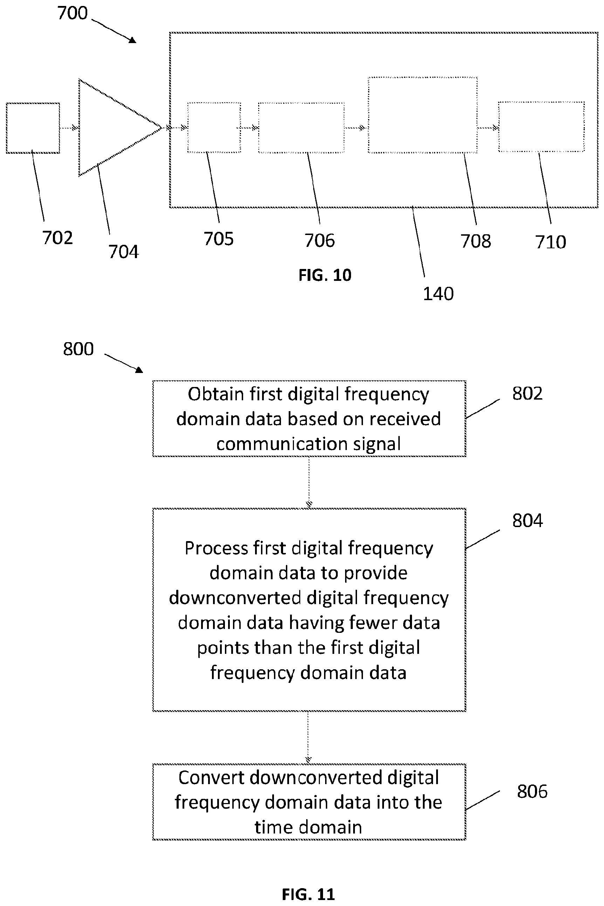

An alternative apparatus 700 for downconverting a received frequency modulated communication signal is illustrated in Fig. 10. It will be assumed for brevity in the following discussion that the received frequency modulated communication signal is a payload data signal received from another communications node by way of a communication channel, but it will be understood that the same process may be used to downconvert a received calibration signal (which may also be received by way of the communication channel from the another communications node), the calibration signal being used to derive a calibration function by which to process the frequency modulated communication (e.g. data) signal. The receiving node 110, 112 may comprise the apparatus 700 for downconverting and processing received frequency modulated communications signals. The calibration signal may be a calibration signal as discussed above. For example it may be that the calibration signal comprises calibration data encoded based on a respective code. The calibration data may comprise a constant or time varying amplitude. The calibration data may be known by the apparatus 700 (e.g., stored in a memory in communication with the processing circuitry thereof).

The apparatus 700 may comprise an anti-aliasing bandpass filter 702 for bandpass filtering the received frequency modulated communication signal, the anti-aliasing bandpass filter 702 having a passband comprising the frequency band of the communication signal to be downconverted. It may be that the anti-aliasing bandpass filter 702 selectively passes frequencies of less than half of a sampling frequency fs. The apparatus 700 may comprise a low noise amplifier 704 for amplifying the received frequency modulated communication signal, for example after it has been filtered by the bandpass anti-aliasing filter 702. The apparatus 700 may comprise the processing circuitry 140 (or a portion thereof) of the receiving node 110, 112, which may be configured to obtain the frequency modulated communication signal, for example after it has been filtered and amplified by the filter 702 and amplifier 704 respectively. The processing circuitry 140 may be configured to perform the method 800 set out in Fig. 11, although it will be understood that the method of Fig. 11 may be performed be any other suitable apparatus. Although different processing blocks are shown in Fig. 10, and it may be that different processing blocks of the processing circuitry perform the analogue to digital conversion (ADC) 705, FFT 706, processing 708 and iFFT 710, it will be understood that one or more or all of the ADC, FFT, processing and iFFT may be performed by the same (e.g. general purpose) processing circuitry. The method of Fig. 11 may be repeated for received frequency modulated communication signals (e.g. payload data signals, calibration signals, or payload data signals and calibration signals) in each of a plurality of frequency bands of the communication channel.

At 802, the method may comprise obtaining (e.g. complex) first digital frequency domain data based on the received frequency modulated communication signal. The method may comprise receiving the frequency modulated communication signal. The method may comprise converting the received frequency modulated communication signal into the frequency domain to provide the first digital frequency domain data based on the frequency modulated communication signal. For example, the frequency modulated communication signal may be converted into the frequency domain by sampling the received frequency modulated communication signal (e.g. by way of analogue to digital conversion) by a or the sampling frequency and performing a Fast Fourier Transform, FFT, on the sampled frequency modulated communication signal. The frequency modulated communication signal may be oversampled (e.g. it may be that the frequency modulated communication signal is sampled with a sampling frequency in excess of twice the bandwidth of a target frequency band of the frequency modulated communication signal). The resulting digital frequency domain data (i.e. the first digital frequency domain data) may comprise a first signal component at the target frequency band of the signal to be downconverted and a second signal component, the second signal component being a copy of the first signal component folded about half the sampling frequency.

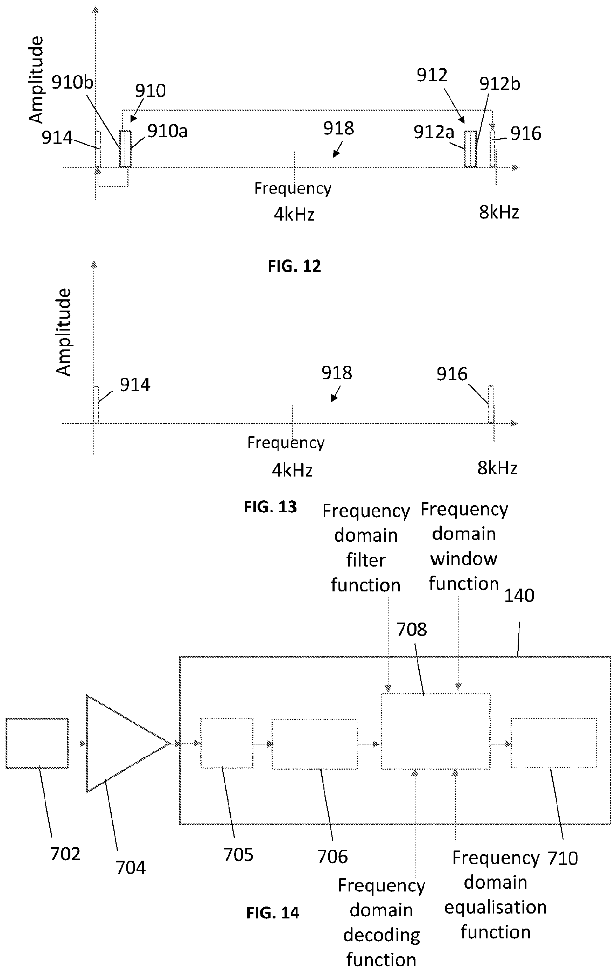

As illustrated in Fig. 12, in an example where the frequency modulated communication signal comprises a target frequency band extending from 600-700Hz and the sampling frequency is 8kHz, the frequency domain signal may comprise a first signal component 910 at the target frequency band 600-700Hz and a second signal component 912 at 7300-7400Hz corresponding to the first signal component 910 in the target frequency band 600-700Hz, the second signal component 912 being a copy of the first signal component 910 folded about half the 8kHz sampling frequency (4kHz). Any suitable frequency bands and sampling frequency may be employed.

At 804, the method may comprise processing the first digital frequency domain data in the frequency domain to provide downconverted digital frequency domain data. The processing may comprise frequency shifting (e.g. downconverting) data based on at least a portion of the first digital frequency domain data. The downconverted digital frequency domain data may have fewer data points than the first digital frequency domain data. For example, the processing may comprise reducing a quantity of data points from a first quantity of data points in the first digital frequency domain data to a second quantity of data points in the downconverted digital frequency domain data, the second quantity being less than the first quantity. As discussed below with respect to 806, by providing the downconverted frequency domain data with fewer data points than the first digital frequency domain data, the processing overhead for converting the downconverted frequency domain data into the time domain is greatly reduced.

In a similar way to the downconverted signal of Fig. 8, the downconverted digital frequency domain data may comprise first data in a first frequency range and second data in a second frequency range different from the first frequency range. The first data may be based on a first portion of the first digital frequency domain data corresponding to a first portion of the target frequency band. The second data may be based on a second portion of the first digital frequency domain data corresponding to a second portion of the target frequency band different from the first portion of the target frequency band. The processing may comprise frequency shifting (e.g. translating in frequency) data based on the first portion of the first digital frequency domain data corresponding to the first portion of the target frequency band to the first frequency range. The processing may comprise frequency shifting (e.g. translating in frequency) data based on the second portion of the first digital frequency domain data corresponding to the second portion of the target frequency band to the second frequency range. It may be that the target bandwidth of the received frequency modulated communication signal consists of the first and second portions thereof.

It may be that the first and second portions of the first digital frequency domain data corresponding to the first and second portions of the target frequency band comprise first and second portions of the first digital frequency domain data in the target frequency band (the first signal component), first and second portions of the first digital frequency domain data in the copy of the target frequency band folded about half the sampling frequency of the first digital frequency domain data (the second signal component), or any combination thereof. Thus, the data based on the first portion of the first digital frequency domain data frequency shifted to the first frequency range may be based on a portion (e.g. an upper frequency portion of) of the first signal component (at the target frequency band) corresponding to the first portion of the target frequency band or a portion (e.g. a lower frequency portion of) the second signal component (the folded copy of the first signal component about half the sampling frequency) corresponding to the first portion of the target frequency band (or any combination thereof). The data based on the second portion of the first digital frequency domain data frequency shifted to the second frequency range may be based on a portion of (e.g. a lower frequency portion of) the first signal component (at the target frequency band) corresponding to the second portion of the target frequency band or a portion (e.g. an upper frequency portion) of the second signal component (the folded copy of the first signal component about half the sampling frequency) corresponding to the second portion of the target frequency band (or any combination thereof).

It may be that frequency shifting (e.g. translating in frequency) the data based on the first portion of the first digital frequency domain data corresponding to the first portion of the target frequency band to the first frequency range comprises frequency shifting the said data by one or more frequency offsets. It may be that the frequency offset applied is dependent on whether the data corresponding to the first portion of the target frequency band is based on the first signal component of the first digital frequency domain data or the second signal component of the first digital frequency domain data. For example, when data corresponding to the first portion of the target frequency band is based on a portion of the first signal component of the first digital frequency domain data, it may be that a frequency offset equal to the carrier frequency is applied. When data corresponding to the first portion of the target frequency band is based on a portion of the second signal component of the first digital frequency domain data, it may be that a frequency offset equal to the sampling frequency minus the upper end frequency of the target bandwidth is applied. It may be that, for example when data corresponding to the first portion of the target frequency band is based on a portion of the second signal component of the first digital frequency domain data, the frequency shifting further comprises rotating the frequency of the said data about its midpoint frequency. In this case (where both frequency shifting by a frequency offset and rotation are provided), it may be that the frequency shifting by the frequency offset and the rotation about the midpoint frequency are performed in separate operations or in a combined operation. In addition, it may be that, when data corresponding to the target frequency band is based on the second signal component (or a portion thereof) of the first digital frequency domain data, complex conjugates are taken of complex values of the second signal component (or a portion thereof) of the first digital frequency domain data.

It may be that frequency shifting (e.g. translating in frequency) the data based on the second portion of the first digital frequency domain data corresponding to the second portion of the target frequency band to the second frequency range comprises frequency shifting the said data by one or more frequency offsets. It may be that the frequency offset applied is dependent on whether the data corresponding to the second portion of the target frequency band is based on the first signal component of the first digital frequency domain data or the second signal component of the first digital frequency domain data. The frequency offset(s) applied to the data based on the second portion of the first digital frequency domain data may be different from the frequency offset(s) applied to the data based on the first portion of the first digital frequency domain data. For example, when data corresponding to the second portion of the target frequency band is based on a portion of the first signal component of the first digital frequency domain data, it may be that a frequency offset equal to the sampling frequency minus the carrier frequency is applied. When data corresponding to the second portion of the target frequency band is based on a portion of the second signal component of the first digital frequency domain data, it may be that a frequency offset equal to the lower end frequency of the target bandwidth is applied. It may be that, for example when data corresponding to the second portion of the target frequency band is based on a portion of the second signal component of the first digital frequency domain data, the frequency shifting further comprises rotating the frequency of the said data about its midpoint frequency. In this case (where both frequency shifting by the frequency offset and rotation are provided), it may be that the frequency shifting by the frequency offset and the rotation about the midpoint frequency are performed in separate operations or in a combined operation. In addition, it may be that, when data corresponding to the target frequency band is based on the second signal component (or a portion thereof) of the first digital frequency domain data, complex conjugates are taken of complex values of the second signal component (or a portion thereof) of the first digital frequency domain data.

As discussed, it may be that the frequency modulated communication signal comprises payload data encoded, for example, by a spread spectrum code such as a chirp. It may be that the carrier frequency is based on the spread spectrum code. For example, it may be that the communication signal comprises payload data encoded based on a (e.g. linear) chirp code. In this case, it may be that the carrier frequency is a mid-point frequency of the chirp code.

The target frequency band may consist of the first and second portions thereof. It may be that the first portion of the target frequency band comprises a first half band of the target frequency band of the received frequency modulated communication signal and the second portion of the target frequency band comprises a second half band of the target frequency band of the received frequency modulated communication signal different from the first half band. It may be that the first frequency range extends from 0Hz (DC) to a frequency equal to a first proportion (e.g. half) of the bandwidth of the target frequency band of the received frequency modulated communication signal. It may be that the second frequency range extends from a first frequency to a second frequency, the second frequency being equal to the sampling frequency and the first frequency being equal to the sampling frequency minus a second proportion (e.g. half) of the bandwidth of the target frequency band of the received frequency modulated communication signal. The first and second proportions may together provide the complete bandwidth of the target frequency band of the frequency modulated communication signal.

In an example, a first portion (e.g. the upper half-band) of the first signal component may be frequency shifted down to the first frequency range (e.g. between DC and half the target bandwidth), while a second portion (e.g. the lower half-band) of the first signal component may be frequency shifted up to the second frequency range (e.g. between a first frequency and a second frequency, the first frequency being equal to the sampling frequency minus half the target bandwidth and the second frequency being equal to the sampling frequency). Equivalently, a first portion (e.g. the lower half-band) of the second signal component may be rotated about its midpoint frequency and frequency shifted down to the first frequency range (e.g. between DC and half the target bandwidth), while a second portion (e.g. the upper half-band) of the second signal component may be rotated about its midpoint frequency and frequency shifted up to the second frequency range (e.g. between a first frequency and a second frequency, the first frequency being equal to the sampling frequency minus half the target bandwidth and the second frequency being equal to the sampling frequency). Any equivalent combination of the above may be performed. As above, when data from the second component is used, it may be that complex conjugates are taken of complex values of the relevant portion of the second signal component.

In the example of Fig. 12, a first portion 910a of the target bandwidth of the first signal component 910 (in this example from 650-700Hz) may be frequency shifted down to a first frequency range 914 (in this example 0-50Hz), while a second portion 910b of the target bandwidth of the first signal component 910 (in this example 600-650Hz) may be frequency shifted up to a second frequency range 916 (in this example 7950-8000Hz). Equivalently, a first portion 912a of the target bandwidth of the second signal component 912 (in this example from 7300-7350Hz) may be rotated about its midpoint frequency and frequency shifted down to the first frequency range 914 (in this example 0-50Hz), while a second portion 912b of the target bandwidth of the second signal component 912 (in this example from 7350-7400Hz) may be rotated about its midpoint frequency and frequency shifted up to the second frequency range 916 (in this example 7950-8000Hz). The carrier frequency in this case may be considered to be 650Hz. Any equivalent combination of the above may be performed. The result of this frequency translation is illustrated in Fig. 13, which shows signals corresponding to the target bandwidth of Fig. 12 translated to the first and second frequency ranges 914, 916. As above, it may be that complex conjugates are taken of complex values of the relevant portion of the second signal component 912.

The downconverted digital frequency domain data may further comprise intermediate data between the first and second frequency ranges. For example, intermediate data 918 is provided between the first and second frequency ranges 914, 916 in the example of Fig. 13, the intermediate data filtered to have (i.e. set to) zero values. Providing intermediate data between the first and second frequency ranges helps to inhibit leakage between the first and second frequency ranges, for example when converting the downconverted digital frequency domain data to the time domain at 806 (see below). The intermediate data between the first and second frequency ranges may be digitally filtered in the frequency domain, for example by setting the intermediate data to have null or zero values. Alternatively, it may be that the data based on the first digital frequency domain data is provided in a first data array and the downconverted digital frequency domain data is provided in a second data array separate from the first data array. In this case, it may be that the data based on the first and second portions of the first digital frequency domain data is selectively shifted to the first and second frequency ranges of a second data array comprising intermediate data in an intermediate frequency range between the first and second frequency ranges. The values of the intermediate data in the second data array may be set (e.g. preset) to zero. The values of the intermediate data in the second data array may be preset to zero or they may be set to zero by way of a filter function (e.g. by way of multiplication in the frequency domain by a filter function). The second data array may be the same size as the first data array.

The spectrum of the signal after frequency shifting of the data based on the first and second portions of the first digital frequency domain data corresponding to the first and second portions of the target frequency band to the first and second frequency ranges may be similar to the output of the mixing by the apparatus of Figs. 4b, 5, as shown in Fig. 8 but the signal is in the frequency domain rather than in the time domain. Thus, the frequency shifting discussed above, performed in the frequency domain, may correspond to a quadrature downconversion performed in the time domain. It will be understood that the downconverted digital frequency domain data may be considered to be downconverted relative to the first digital frequency domain data in a similar sense to the data downconverted in the time domain by the methods of Figs. 4a, 4b, even though the frequencies of the second frequency range may be greater than the upper frequency of the target frequency band.

At 804, the frequency domain data may be further processed by the processing circuitry 140 in the frequency domain, either before or after the said frequency shifting. For example, the frequency domain data may be any one or more of equalised, decoded, windowed in the frequency domain. This will be explained further below. At 806, the downconverted digital frequency domain data may be converted into the time domain. For example, the downconverted digital frequency domain data may be converted into the time domain by way of an inverse fast Fourier transform, iFFT, performed thereon.

As mentioned above, converting signals between the frequency and time domains (e.g. by way of FFT or iFFT) is computationally expensive. However, as also mentioned above, it may be that, at 804, the processing involves reducing the quantity of data points from a first quantity of data points of the first digital frequency domain data to a second quantity of data points of the downconverted digital frequency domain data, the second quantity being less than the first quantity. For example, it may be that, at 804, the processing involves decimating in the frequency domain the intermediate data between the first and second frequency ranges, such as the intermediate data 918 between first and second frequency ranges 914, 916 of Fig. 13, by a decimation factor in order to provide the downconverted digital frequency domain data with fewer data points than the first digital frequency domain data. Reducing the number of data points in the downconverted digital frequency domain data reduces the quantity of data which is subsequently converted from the frequency domain into the time domain (e.g. by iFFT), thereby reducing computational and memory requirements.

The intermediate data may be decimated by a factor of 10, or the intermediate data may be decimated by a factor other than 10; any suitable decimation factor may be applied. It will be understood that decimation by a decimation factor of n may refer to retaining every n^{th} sample (e.g. of the intermediate data). Decimation may comprise discarding the remaining samples (e.g. of the intermediate data). It may be that the method comprises decimating the intermediate data by discarding samples thereof to thereby multiply a sampling time or, equivalently, divide a sampling rate of the intermediate data by a decimation factor. It may be that the decimation factor is an integer. It may be that the decimation factor is greater than one. It may be that the processing comprises decimating the intermediate data to a greater extent than the first and second data in the first and second frequency ranges, to thereby preserve the signal samples in the portions of the downconverted signal containing the signal information. It may be that the first and second data in the first and second frequency ranges are decimated or it may be that the first and second data in the first and second frequency ranges are not decimated.

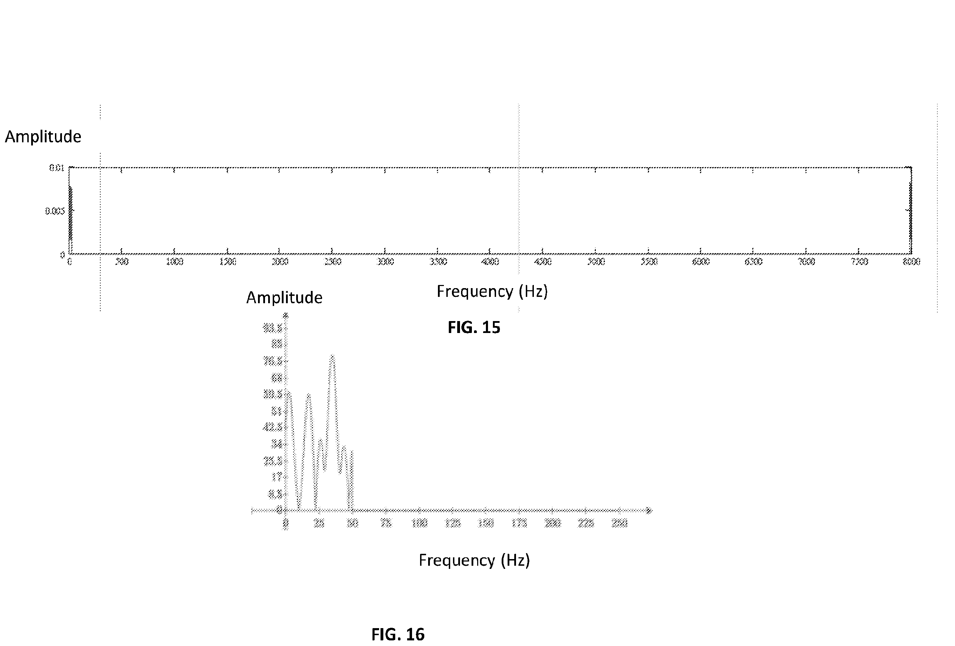

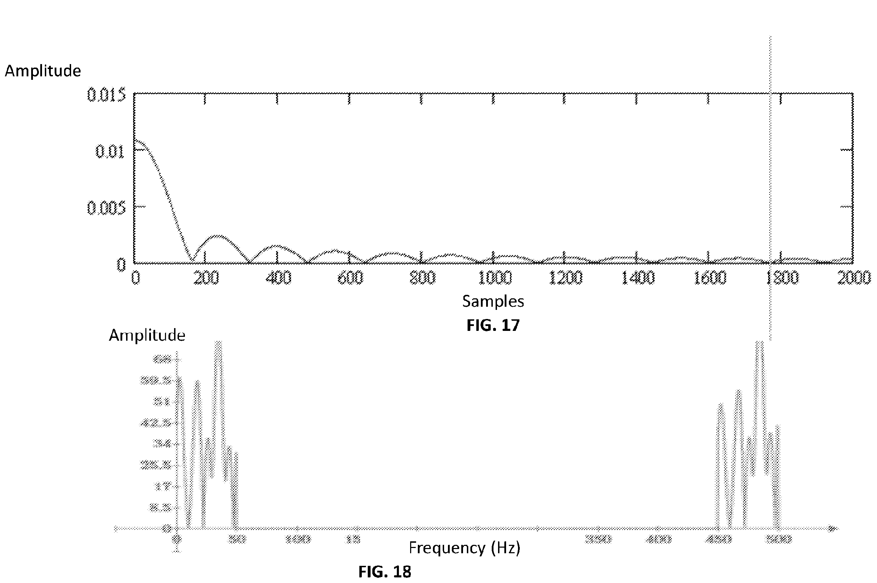

By decimating the intermediate data in the frequency domain, the frequency gap between the first and second frequency ranges narrows such that the second frequency range is further frequency shifted so that it extends from a first frequency to a second frequency, the second frequency being lower than the sampling frequency of the first digital frequency domain data and the first frequency being the second frequency minus a proportion (e.g. half) of the bandwidth of the target frequency band (see Figs. 15 and 18 discussed below). In theory, because the frequency domain data has complex values, the sampling frequency of the first digital frequency domain data can be reduced to the target bandwidth of the frequency modulated communication signal with no intermediate data between the first and second frequency ranges (e.g. the second frequency range may be contiguous with the first frequency range). However, it may be that some intermediate data is kept between the first and second frequency ranges of the downconverted digital frequency domain data to provide a guard band between the first and second frequency ranges to inhibit leakage between them. It may be that (e.g. after decimation) the frequency range extending between a lower end of the first frequency range and an upper end of the second frequency range of the downconverted digital frequency domain data is greater than or equal to twice the bandwidth of the target frequency band. The decimation factor may be selected so as to not cause overlap between the first and second data in the frequency domain. It may be that the first and second data are discrete from each other in frequency following decimation of the intermediate data. The desired size of the guard band may be determined empirically.

As mentioned above, it may be that the data points corresponding to the first and second data are not decimated. It may be that the first and second data are based on all or substantially all of the information in the first digital frequency domain data relating to the target frequency band. For example, it may be that the first data is based on all (or substantially all, such as at least 90%, at least 95% or at least 99% of the) data points corresponding to the first portion of the target frequency band from a corresponding portion (e.g. upper half-band) of the bandwidth of the first signal component or on all (or substantially all, such as at least 90%, at least 95% or at least 99% of the) data points corresponding to the first portion of the target frequency band from a corresponding portion (e.g. lower half-band) of the bandwidth of the second signal component (or any combination thereof). Similarly, it may be that the second data is based on all (or substantially all, such as at least 90%, at least 95% or at least 99% of the) data points corresponding to the second portion of the target frequency band from a corresponding portion (e.g. lower half-band) of the bandwidth of the first signal component or on all (or substantially all, such as at least 90%, at least 95% or at least 99% of the) data points corresponding to the second portion of the target frequency band from a corresponding portion (e.g. upper half-band) of the bandwidth of the second signal component (or any combination thereof).

An alternative to the above method of reducing the quantity of data points from the first quantity to the second quantity, and thus to reduce the computational and memory requirements of converting the downconverted digital frequency domain data into the time domain, is as follows. The first digital frequency domain data may be provided in a first data array. The processing may comprise selectively shifting (e.g. selected) data based on the first and second portions of the first digital frequency domain data corresponding to first and second portions of the target frequency band to a second data array smaller than the first data array. It may be that the target frequency band consists of the first and second portions thereof. The data based on the first and second portions of the first digital frequency domain data may be shifted to respective first and second frequency ranges of the second data array to provide downconverted digital frequency domain data. Data based on the first digital frequency domain data outside of the first and second portions thereof may be discarded. Intermediate data may be provided in an intermediate frequency range between the first and second frequency ranges of the second data array (e.g. to provide a guard band between the first and second frequency ranges). The values of the intermediate data (where provided) may be set (e.g. preset) to zero. The values of the intermediate data may be preset to zero or they may be set to zero by way of a filter function (e.g. by way of multiplication in the frequency domain by a filter function). The downconverted digital frequency domain data may be provided with fewer data points than the first digital frequency domain data by the second data array having fewer data points than the first data array. For example, it may be that the quantity of data points of the intermediate data (where provided) of the downconverted digital frequency domain data is lower than the quantity of data points of the first digital frequency domain data outside of the first and second portions thereof. In some cases it may be that there is no intermediate data between the first and second frequency ranges in the downconverted digital frequency domain data (e.g. it may be that the first and second frequency ranges are contiguous). The quantity of data points in the first and second frequency ranges of the downconverted digital frequency domain data may be the same or substantially the same as (e.g. at least 90%, at least 95% or at least 99% of) the quantity of data points in the first and second portions of the first digital frequency domain data so as to retain all or substantially all of the signal information in the target frequency band of the first digital frequency domain data.

In this case, it may be that the first data of the downconverted digital frequency domain data in the second data array is provided in a first frequency range extending from DC (0Hz) to a first proportion (e.g. half) of the target frequency band. It may be that the second data of the downconverted digital frequency domain data is provided in a second frequency range extending from a first frequency to a second frequency, the second frequency being lower than the sampling frequency of the first digital frequency domain data and the first frequency being the second frequency minus a second proportion (e.g. half) of the target frequency band. The second frequency may be the sampling frequency of the first digital frequency domain data scaled down by a scaling factor. The scaling factor may be an integer. The scaling factor may be greater than one. This method is equivalent to the above described method of generating data comprising first data, second data and intermediate data and selectively decimating the intermediate data to generate the downconverted digital frequency domain data having fewer data points than the first digital frequency domain data, but is computationally simpler.

As before, it may be that the data points corresponding to the first and second data are not decimated. As mentioned above, it may be that the first and second data are based on all or substantially all of the information in the first digital frequency domain data relating to the target frequency band. For example, it may be that the first data is based on all (or substantially all, such as at least 90%, at least 95% or at least 99% of the) data points corresponding to the first portion of the target frequency band from a corresponding portion (e.g. upper half-band) of the bandwidth of the first signal component or on all (or substantially all, such as at least 90%, at least 95% or at least 99% of the) data points corresponding to the first portion of the target frequency band from a corresponding portion (e.g. lower half-band) of the bandwidth of the second signal component (or any combination thereof). Similarly, it may be that the second data is based on all (or substantially all, such as at least 90%, at least 95% or at least 99% of the) data points corresponding to the second portion of the target frequency band from a corresponding portion (e.g. lower half-band) of the bandwidth of the first signal component or on all (or substantially all, such as at least 90%, at least 95% or at least 99% of the) data points corresponding to the second portion of the target frequency band from a corresponding portion (e.g. upper half-band) of the bandwidth of the second signal component (or any combination thereof).

As before, it may be that the first and second frequency ranges are discrete from (i.e. do not overlap) each other. It may be that the downconverted digital frequency domain data comprises intermediate data which provides a guard band between the first and second frequency ranges to inhibit leakage between them. It may be that (e.g. after shifting to the first and second frequency ranges of the second array) the frequency range extending between a lower end of the first frequency range and an upper end of the second frequency range of the downconverted digital frequency domain data is greater than or equal to twice the bandwidth of the target frequency band. The scaling factor may be selected so as to not cause overlap between the first and second data in the frequency domain. It may be that the first and second data are discrete from each other in frequency following decimation of the intermediate data. The desired size of the guard band may be determined empirically.

In this case, it may be that the frequency shifting of the data based on the first portion of the first digital frequency domain data corresponding to the first portion of the target frequency band to the first frequency range is as before. It may be that the frequency offset(s) by which the data based on the second portion of the first digital frequency domain data corresponding to the second portion of the target frequency band is frequency shifted to the second frequency range (and indeed the location in frequency of the second frequency range itself) is based on the desired reduction in the quantity of data points from the first quantity in the first digital frequency domain data to the second quantity in the downconverted digital frequency domain data.

It may be that (e.g. at least) first and second target frequency bands of the frequency modulated communication signal are selected for downconversion. In this case, it may be that data based on first and second portions of the first digital frequency domain data corresponding to first and second portions of the first target frequency band (e.g. the first target frequency band consisting of the first and second portions thereof) are shifted to a second data array and that data based on first and second portions of the first digital frequency domain data corresponding to first and second portions of the second target frequency band (e.g. the second target frequency band consisting of the first and second portions thereof) are shifted to a third data array. It may be that each of the second and third data arrays have fewer data points than the first data array.

As above, for each of the target frequency bands, the data based on the first and second portions of the first digital frequency domain data may be shifted to respective first and second frequency ranges of the respective second and third data arrays to provide downconverted digital frequency domain data for each of the target frequency bands. For each of the target frequency bands, data based on the first digital frequency domain data outside of the first and second portions thereof may be discarded. For each of the second and third data arrays, intermediate data may be provided in an intermediate frequency range between the first and second frequency ranges (e.g. to provide a guard band between the first and second frequency ranges). The values of the intermediate data (where provided) may be set (e.g. preset) to zero. The values of the intermediate data may be preset to zero or they may be set to zero by way of a filter function (e.g. by way of multiplication in the frequency domain by a filter function). The downconverted digital frequency domain data for each of the target frequency bands may be provided with fewer data points than the first digital frequency domain data by the second and third data arrays having fewer data points than the first data array. For example, it may be that, for each of the second and third data arrays, the quantity of data points of the intermediate data (where provided) is lower than the quantity of data points of the first digital frequency domain data outside of the first and second portions thereof. In some cases, it may be that there is no intermediate data between the first and second frequency ranges (e.g. it may be that the first and second frequency ranges are contiguous). The quantity of data points in the first and second frequency ranges of the second and third arrays may be the same or substantially the same as (e.g. at least 90%, at least 95% or at least 99% of) the quantity of data points in the respective first and second portions of the first digital frequency domain data so as to retain all or substantially all of the signal information in the respective target frequency band of the first digital frequency domain data.

The digital frequency domain data in each of the second and third data arrays may be converted to the time domain, for example by iFFT operations. As the second and third data arrays each have fewer data points than the first digital frequency domain data, the number of iFFT operations to be performed is correspondingly reduced.

By either of the above methods, the processing may comprise reducing a quantity of data points from a first quantity of data points in the first digital frequency domain data to a second quantity of data points in the downconverted digital frequency domain data, the second quantity being less than the first quantity. This may be achieved by selective data decimation (by the first method), or by selectively shifting data into a smaller data array (by the second method). In either of the above methods, it may be that a ratio of a number of data points of the first digital frequency domain data within the target frequency band (or in the combination of the said first and second portions of the first digital frequency domain data) to a number of data points of the first digital frequency domain data outside of the target frequency band is less than a ratio of a number of data points in the combination of the first and second data of the downconverted digital frequency domain data to a number of data points of the intermediate data of the downconverted digital frequency domain data. Similarly, it may be that a ratio of a number of data points of the first digital frequency domain data within the target frequency band (or in the combination of the first and second portions of the first digital frequency domain data) to a total number of data points of the first digital frequency domain data is less than a ratio of a number of data points in the combination of the first and second data of the downconverted digital frequency domain data to a total number of data points of the downconverted digital frequency domain data.

By discarding data outside of the first and second portions of the data based on the first digital frequency domain data and retaining the information corresponding to the target frequency band in the first and second portions of the said data based on the first digital frequency domain data, the quantity of iFFT processing required to convert the downconverted digital frequency domain data into the time domain at 806 is reduced while retaining the quality of the recovered time domain signal.

The processing at 804 may further comprise performing one or more frequency domain multiplications. It may be that the frequency domain multiplications are performed (e.g., selectively) on data based on at least a portion of the first digital frequency domain data, such as data based on the said first and second portions of the first digital frequency domain data corresponding to first and second portions of the target frequency band. As set out above, the processing at 804 may comprise frequency shifting data based on first and second portions of the first digital frequency domain data corresponding to first and second portions of the target frequency band to the first and second frequency ranges. The processing at 804 may further comprise reducing the quantity of data points from the first quantity of data points of the first digital frequency domain data to the second quantity of data points of the downconverted digital frequency domain data, the second quantity being less than the first quantity. It may be that the frequency domain multiplications at 804 are performed prior to or after the said frequency shifting. It may be that the frequency domain multiplications at 804 are performed prior to or after the said reduction in the quantity of data points. It may be that the frequency domain multiplications at 804 are performed prior to or after the said shifting to the second array (where provided). It will be understood that it is more efficient to perform the frequency domain multiplications after the said reduction in the quantity of data points due to the resulting reduction in frequency domain multiplication operations.

It may be that the data based on at least a portion of the first digital frequency domain data which is frequency shifted comprises at least a portion of the first digital frequency domain data or at least a portion of the result of frequency domain multiplications performed on at least a portion of data from the first digital frequency domain data (e.g. to perform any one or more of filtering, windowing, equalising the effects of the communication channel on, or decoding the at least a portion of the first digital frequency domain data).

For example, as illustrated at Fig. 14, it may be that the processing is to comprise any one or more of the following performed (e.g. by way of frequency domain multiplications) in the frequency domain: filtering; windowing (e.g. by way of a Hanning or Kaiser window function); equalising the effects (e.g. cancelling echo effects) of a communication channel; decoding. It may be that the any one or more of filtering, windowing, equalising, decoding are performed by way of frequency domain multiplications.

As discussed above, filtering the frequency shifted frequency domain data may be performed by multiplying the values of the intermediate data between the first and second frequency ranges by zero. Alternatively, the intermediate data between the first and second frequency ranges may be set (e.g. preset) to null or zero values, for example by setting (e.g. presetting) the intermediate data values of the second (or third as the case may be) array to zero.

The said windowing may be performed to reduce side lobes caused by the conversion of the frequency modulated communication signal into the frequency domain, for example in order to reduce inter-symbol interference. Windowing may be performed by way of a frequency domain multiplication by a windowing function. It may be that windowing is alternatively performed on the received frequency modulated communication signal prior to conversion to the frequency domain (i.e. in the time domain).

Decoding may be performed by frequency domain multiplication by a frequency domain decoding function. Similarly equalisation may be performed by frequency domain multiplication by a frequency domain equalisation function.

Decoding may comprise multiplication by a frequency domain reference signal. The frequency domain reference signal may be based on a complex conjugate of a frequency domain version of the code on which the communication signal (or at least the component of the communication signal in the target frequency band) is based. The frequency domain reference signal may be a complex conjugate of a frequency domain version of a (e.g. pre-computed) downconversion of the code on which the communication signal is based. It may be that the downconversion of the code corresponds to the downconversion performed on the frequency modulated communication signal. As discussed above, multiplication of a frequency domain signal by the complex conjugate of a function is equivalent to correlation in the time domain of the signal with the function. It may be that the frequency domain reference signal is a predetermined frequency domain reference signal. The predetermined frequency domain reference signal may be stored in and retrieved from the memory 144 of the receiving node.

It may be that equalising the effects of the communication channel on the said data based on the at least first and second portions of the first digital frequency domain data comprises processing the data in dependence on a calibration function, such as a calibration function derived from a calibration signal received by way of the communication channel. It may be that equalising the effects of the communication channel on the said data comprises multiplying the said data by the calibration function in the frequency domain. It may be that the processing circuitry is to determine a calibration function depending on a received calibration signal. It may be that the receiver (where provided) is to receive a calibration signal by way of the communication channel. It may be that the calibration signal overlaps in frequency with the target frequency band. It may be that the calibration signal comprises or consists of frequencies within the target frequency band.

For example, the receiver of the receiving node 110, 112 may be to receive a calibration signal from the transmitting node by way of the communication channel, derive a frequency domain calibration function from the received calibration signal (e.g. by converting the received calibration signal into the frequency domain, for example by sampling and performing an FFT thereon, downconverting (e.g. by frequency shifting and reducing the number of data points in the same way as the frequency modulated communication signal) the target frequency band of received calibration signal (which may be the same as or similar to the target frequency band of the communication signal) and determining the calibration function in the frequency domain by determining the inverse of the downconverted frequency domain calibration signal) and multiply the data based on the at least said first and second portions of the first digital frequency domain data by the calibration function in the frequency domain.

It may be that determining the calibration function depending on the calibration signal comprises decoding the calibration signal (e.g. for example in any of the ways mentioned above for the decoding of the communication signal, such as by multiplying the calibration signal by a reference signal based on a complex conjugate of a code in respect of which the calibration signal is encoded). In this case, it may be that the calibration function is determined based on the decoded calibration signal. It may be that the calibration function is a predetermined calibration function, which may be stored in and retrieved from the memory 144 of the receiving node.

As discussed above, it may be that the calibration signal and the frequency modulated communication signal at least partially overlap with each other in time and frequency. In this case, it may be that the calibration signal and the frequency modulated communication signal are encoded based on different codes to allow them to be discriminated from each other. For example, it may be that the calibration signal is encoded based on a code which is orthogonal or pseudo-orthogonal to the code by which the frequency modulated communication signal is encoded. The codes may be orthogonal with each other by way of their time variance. This is particularly beneficial when the transfer function of the communication channel is quickly varying, for example during dynamic deployments such as during downhole drilling, as it can be ensured that the transfer function of the communication channel is substantially the same for both the calibration signal and the target frequency band of the frequency modulated communication signal.

It may be that processing the said data depending on the calibration function both decodes the frequency modulated communication signal and equalises the effects of the communication channel thereon. For example, it may be that the calibration signal and the frequency modulated communication signal are encoded based on a common code (e.g. each of the calibration signal and the frequency modulated communication signal may be encoded in dependence on a code in common with each other). It may be that the calibration signal is received before or after the frequency modulated communication signal. It may be that the calibration function is derived from the calibration signal (e.g. by the receiving node) such that the calibration function depends on the common code by way of the dependency of the calibration signal thereon (e.g. without removing the dependency of the received calibration signal on the common code). The calibration function may be a frequency domain calibration function. It may be that the receiving node is to multiply the said data based on at least the first and second portions of the first digital frequency domain data by the calibration function in the frequency domain.

It may be that the processing circuitry 140 of the receiving node is to derive the calibration function from the received calibration signal by obtaining an inverse of the calibration signal in the frequency domain (e.g. by obtaining the inverse of the magnitude and the complex conjugate of the phase). The processing circuitry 140 may be configured to downconvert the calibration signal as discussed above and determine the calibration function by obtaining an inverse of the downconverted calibration signal in the frequency domain (e.g. by obtaining the inverse of the magnitude and the complex conjugate of the phase of the downconverted calibration signal).

As discussed above, because the calibration signal and the frequency modulated communication signal have passed through the same communication channel, the calibration signal may be dependent on the transfer function of the communication channel. Additionally, by deriving the calibration function from the calibration signal such that the calibration function depends on the common code by way of the dependency of the calibration signal thereon (e.g. without removing the dependency of the received calibration signal on the common code), the calibration function is further dependent on the common code. It may be that the calibration function is provided with information for decoding the communication signal, such as information concerning the common code, by way of the calibration signal. It may be that the calibration function is implicitly provided with information concerning the common code for decoding the frequency modulated communication signal by way of the calibration signal. The calibration function may be implicitly provided with the said information in the sense that the common code is not explicitly determined from the calibration signal, but that information concerning the common code is contained within the calibration function derived therefrom. Thus, the frequency modulated communication signal can be decoded without prior knowledge of the common code by processing the frequency modulated communication signal depending on the calibration function. In addition, processing the data based on the at least a portion of the first digital frequency domain data by the calibration function both removes the dependency of the frequency modulated communication signal on the common code (i.e. the frequency modulated communication signal can be decoded) and equalise the effects of the communication channel on the frequency modulated communication signal.

Frequency domain multiplication is equivalent to time domain convolution but is more computationally efficient. Accordingly, it is more computationally efficient to perform the filtering, windowing, decoding and equalising (where provided) in the frequency domain than in the time domain. It may be that a plurality of functions are combined into a single (e.g. pre-computed) function and that the processing comprises multiplying the frequency domain data by the said combined function in the frequency domain. For example, it may be that any two or more of filtering, windowing, decoding and equalising functions are combined into a single (e.g. pre-computed) function and that the frequency domain data is multiplied by the said combined function in the frequency domain. Reducing processing in this way is a particular advantage in downhole applications where computational resources (e.g. processing capacity and memory) are limited due to the hostility of the environment.

By the processing of the communication signal comprising multiplication (e.g. by any one or more of equalisation, filtering, windowing and decoding functions) in the frequency domain and reducing the number of data points in the frequency domain prior to converting the processed frequency domain signal into the time domain, the reduction in computational expense obtained by performing multiplications in the frequency domain, rather than time domain convolutions or correlations, can be better realised due to the significantly reduced number of calculations for converting the processed frequency domain data into the time domain. The number of complex multiplications for performing an IFFT may be determined by (N/2)*log₂(N), where N is the number of data points in the data being converted by way of the IFFT. By reducing the number of data points in the data to be converted by way of the IFFT from N1 data points in the first digital frequency domain data to N2 data points in the downconverted digital frequency domain data, the computational expense for performing the IFFT may be reduced by ((N1/2)*log₂(N1) - (N2/2)*log₂(N2)) complex multiplications. In an example, N1 may be equal to 2¹⁵, while N2 may be equal to 2¹². When it is considered that the downconversion process may be repeated for communication signals received in a plurality of frequency bands, it can be seen that the reduction in computational expense may be even more significant. Again, this reduced computational requirement is a particular benefit in downhole applications where computational resources (e.g. processing capacity and memory) are limited.

It will be understood that the downconverted digital frequency domain data may be complex digital frequency domain data (i.e. digital frequency domain data having complex values). In examples comprising reducing the number of data points from a first number in the first digital frequency domain data to a second number in the downconverted digital frequency domain data, it may be that a number of digital frequency domain data points having complex values (i.e. data points of digital frequency domain data having complex values) is reduced from the first number to the second number. In examples comprising discarding samples of digital frequency domain data, it may be that the discarded samples are samples of complex digital frequency domain data (i.e., digital frequency domain data having complex values).

Figs. 15-19 demonstrate that first digital frequency domain data can be obtained based on a frequency modulated communication signal, that downconverted digital frequency domain data can be generated from the first digital frequency domain data having fewer data points than the first digital frequency domain data, and that the downconverted digital frequency domain data can be converted into the time domain without significant detriment to the output time domain signal. First digital frequency domain data based on a data communication signal received by way of a communication channel may be provided in a first data array, the first digital frequency domain data having a sampling frequency of 8kHz (for example). Fig. 15 shows data based on first and second portions of the first digital frequency domain data corresponding to first and second portions of a target frequency band of the frequency modulated communication signal, the data based on the first and second portions of the first digital frequency domain data having been translated to first and second frequency ranges (0-50Hz and 7950-8000Hz). No reduction in the number of data points has been performed, the sampling frequency of the data of Fig. 15 being 8kHz, the same as the sampling frequency of the first digital frequency domain data. The data has been filtered and decoded and the effects of the communication channel thereon have been equalised. In this example, the bandwidth of the target frequency band is 100Hz. Fig.16 shows the first frequency range 0-50Hz in more detail. Fig. 17 shows the signal of Fig. 15 converted into the time domain by iFFT, the x axis of Fig. 17 being sample number (rather than time per se).

Fig. 18 shows downconverted digital frequency domain data corresponding to the data of Fig. 15 with the number of samples in the downconverted digital frequency domain data having been reduced by a factor of 16 relative to the first digital frequency domain data. The full quantity of the first and second data in the first and second frequency ranges has been retained. As set out above, the data of Fig. 18 may be obtained either by decimating the intermediate data between the first and second frequency ranges in the data of Fig. 15 or by selectively shifting data based on the first and second portions of the first digital frequency domain data into a second array smaller than the first array (e.g. the second array may be a factor of 16 smaller than the first array).

It can be seen from Fig. 18 that the frequency range has been reduced from 0 to 8000Hz to 0 to 500Hz on account of the number of data points in the downconverted digital frequency domain data being a factor of 16 lower than the number of data points in the first digital frequency domain data. The lower band remains at 0 to 50Hz, but the upper band occupies a lower frequency range, 450-500Hz, than the data of Fig. 15. However, it will be understood that the upper frequency after the reduction in the number of data points may be greater (but still typically lower than the original sampling frequency, which was 8000Hz in this case) or lower than 500Hz depending on the factor by which the number of data points is reduced in the downconverted digital frequency domain data as compared to the first digital frequency domain data.

As shown in Fig. 18, the sampling frequency (e.g. 500Hz) after the reduction in the number of data points remains greater than twice the bandwidth (100Hz) of the communication signal and a guard band (50Hz - 450Hz) is maintained between the lower (0-50Hz) and upper frequency ranges (450-500Hz). This helps to ensure that the data within the bandwidth of the communication signal can be recovered from the downconverted digital frequency domain data with little or no leakage between frequency ranges.

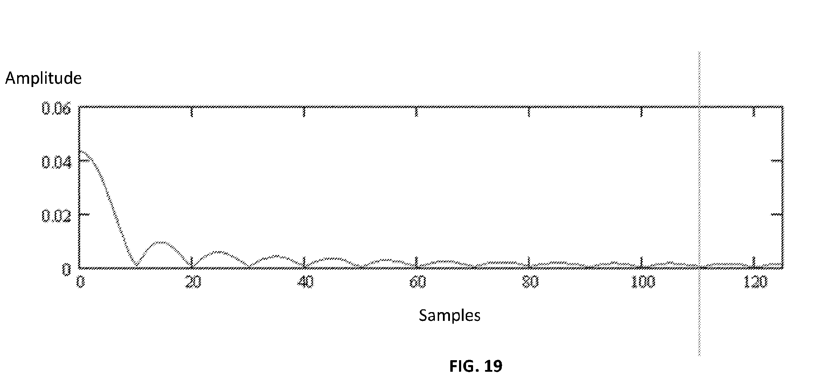

Fig. 19 shows the signal of Fig. 18 converted into the time domain by iFFT, the x-axis of Fig. 19 being sample number (rather than time per se). It can be seen that the waveform of Fig. 19 compares favourably to the waveform of Fig. 17, illustrating that the reduction in the number of data points in the downconverted digital frequency domain data is not to the detriment of the output. It can also be seen from the x-axis scales of Figs. 17 and 19 that there are significantly fewer data points in the waveform of Fig. 19, illustrating the computational expense reduction achieved.

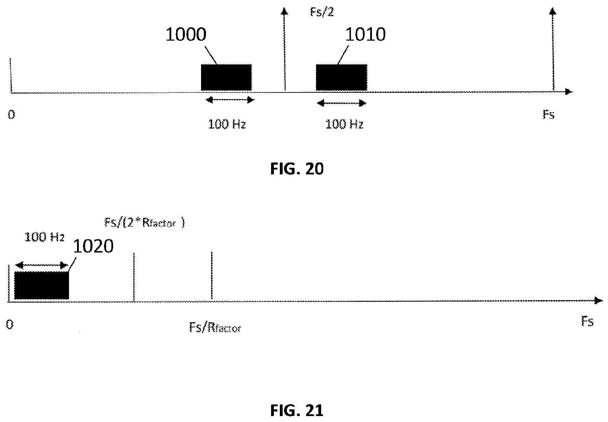

Another example method for downconverting a received frequency modulated communication signal is described with reference to Figs. 20-28. The method may be performed by an apparatus having any of the features of the apparatus 700 described above with respect to Figs. 10, 14. The method may be described with reference to blocks 802-806 of Fig. 11. Accordingly, the blocks of Figs. 10, 14 and 11 will be referred to in the discussion below.

As above, the frequency modulated communication signal may be received by way of a communication channel, such as a downhole communication channel. As above, the frequency modulated communication signal may be a signal based on (e.g., derived from) an acoustic communication signal received by way of an acoustic communication channel such as a downhole acoustic communication channel. As above, the communication signal may comprise a calibration signal or a payload data signal (or at least a portion thereof).

At 802, the method may comprise obtaining first digital frequency domain data based on the received frequency modulated communication signal. The method may comprise receiving the frequency modulated communication signal. The received frequency modulated communication signal may be bandpass filtered by a filter such as an anti-aliasing bandpass filter 702, the filter having a passband comprising the frequency band of the communication signal to be downconverted. It may be that the anti-aliasing bandpass filter 702 selectively passes frequencies of less than or equal to half of a sampling frequency fₛ. The received frequency modulated communication signal may be amplified, for example by a low noise amplifier 704 for amplifying the received frequency modulated communication signal, for example after it has been filtered (e.g., by the bandpass anti-aliasing filter 702). The method may comprise converting the received frequency modulated communication signal into the frequency domain to provide the first digital frequency domain data based on the frequency modulated communication signal. For example, the frequency modulated communication signal may be converted into the frequency domain by sampling the received frequency modulated communication signal (e.g. by way of analogue to digital converter 705) by a or the sampling frequency fₛ and performing a Fast Fourier Transform, FFT, on the sampled frequency modulated communication signal (e.g., by way of FFT block 706). The frequency modulated communication signal may be oversampled (e.g. it may be that the frequency modulated communication signal is sampled with a sampling frequency in excess of twice the bandwidth of a target frequency band of the frequency modulated communication signal). The resulting digital frequency domain data (i.e. the first digital frequency domain data) may comprise a first signal component 1000 at the target frequency band of the signal to be downconverted and a second signal component 1010, the second signal component 1010 being a copy of the first signal component 1000 folded about half the sampling frequency fs (i.e., the hermetian symmetry of the first signal component). This is illustrated in Fig. 20, where the target frequency band is illustrated as a 100Hz BW signal 1000 occupying a frequency range provided below half the sampling frequency fs. Although the bandwidth is illustrated as 100Hz, any suitable bandwidth at any suitable frequency band (e.g. below half the sampling frequency) may be provided. The first digital frequency domain data may be input to processing block 708.

At 804, the method may comprise processing the first digital frequency domain data in the frequency domain to provide downconverted digital frequency domain data. The processing may comprise frequency shifting (e.g. downconverting) data based on at least a portion of the first digital frequency domain data. The downconverted digital frequency domain data may have fewer data points than the first digital frequency domain data. For example, the processing may comprise reducing a quantity of data points from a first quantity of data points in the first digital frequency domain data to a second quantity of data points in the downconverted digital frequency domain data, the second quantity being less than the first quantity. As discussed above and below with respect to block 806 of Fig. 11, by providing the downconverted frequency domain data with fewer data points than the first digital frequency domain data, the processing overhead for converting the downconverted frequency domain data into the time domain is reduced.

As illustrated in Fig. 21, the downconverted digital frequency domain data may comprise first data 1020 based on a first portion of the first digital frequency domain data corresponding to the target frequency band 1000 of the frequency modulated communication signal. The first data 1020 may be provided in a first (e.g., contiguous) frequency range of the downconverted digital frequency domain data extending from a first frequency to a second frequency. The processing may comprise frequency shifting (e.g. translating in frequency) data based on the first portion of the first digital frequency domain data corresponding to the target frequency band to the first frequency range. The frequency shifting may comprise reducing the frequency of the data based on the first portion of the first digital frequency domain data to the first frequency range.

The first frequency range of the downconverted digital frequency domain data may be at frequencies lower than the target frequency band 1000. The first frequency range may extend from a first frequency to a second frequency. The first frequency may be greater than or equal to zero Hz. The second frequency may be equal to the sum of the first frequency and the bandwidth of the target frequency band. The second frequency may be less than or equal to half the sampling frequency of the downconverted digital frequency domain data.

It may be that the first portion of the first digital frequency domain data corresponding to the target frequency band 1000 comprises the first digital frequency domain data in the target frequency band 1000 (the first signal component), the first digital frequency domain data in the copy 1010 of the target frequency band folded about half the sampling frequency of the first digital frequency domain data (the second signal component), or portions of the first digital frequency domain data from each of the first and second signal components 1000, 1010 (e.g., together corresponding to the target frequency band). Thus, the data based on the first portion of the first digital frequency domain data frequency shifted to the first frequency range may be based on the first signal component 1000 (at the target frequency band), the second signal component 1010 (the folded copy of the first signal component about half the sampling frequency corresponding to the target frequency band) or portions of the first digital frequency domain data from each of the first and second signal components 1000, 1010 (e.g., together corresponding to the target frequency band).

It may be that frequency shifting (e.g. translating in frequency) the data based on the first portion of the first digital frequency domain data corresponding to the target frequency band to the first frequency range comprises frequency shifting the said data by one or more frequency offsets. It may be that the frequency offset applied is dependent on whether the data corresponding to the target frequency band is based on the first signal component 1000 of the first digital frequency domain data or the second signal component 1010 of the first digital frequency domain data. For example, when data corresponding to the target frequency band is based on the first signal component 1000 (or a portion thereof) of the first digital frequency domain data, it may be that a frequency offset less than or equal to the frequency of the lower end of the target frequency band is applied. When data corresponding to the target frequency band is based on the second signal component 1010 (or a portion thereof) of the first digital frequency domain data, it may be that a frequency offset equal to the sampling frequency minus the upper end frequency of the target bandwidth is applied. It may be that, for example when data corresponding to the target frequency band is based on the second signal component 1010 (or a portion thereof) of the first digital frequency domain data, the frequency shifting further comprises rotating the frequency of the said data about its midpoint frequency. In this case (where both frequency shifting by a frequency offset and rotation are provided), it may be that the frequency shifting by the frequency offset and the rotation about the midpoint frequency are performed in separate operations or in a combined operation. In addition, it may be that, when data corresponding to the target frequency band is based on the second signal component 1010 (or a portion thereof) of the first digital frequency domain data, complex conjugates are taken of complex values of the second signal component 1010 (or a portion thereof) of the first digital frequency domain data.

As mentioned above, it may be that, at 804, the processing involves reducing a quantity of data points from a first quantity of data points in the first digital frequency domain data to a second quantity of data points in the downconverted digital frequency domain data, the second quantity being less than the first quantity. For example, it may be that, at 804, the processing involves decimating in the frequency domain data outside of the first data (e.g., data at frequencies below, above or below and above the first frequency range) by a decimation factor in order to provide the downconverted digital frequency domain data with fewer data points than the first digital frequency domain data. Reducing the number of data points in the downconverted digital frequency domain data reduces the quantity of data which is subsequently converted from the frequency domain into the time domain (e.g. by iFFT), thereby reducing computational and memory requirements.

The data outside of the first data (e.g., data at frequencies below, above or below and above the first frequency range) may be decimated by a factor of 10, or the data outside of the first data (e.g., data at frequencies below, above or below and above the first frequency range) may be decimated by a factor other than 10; any suitable decimation factor may be applied. It will be understood that decimation by a decimation factor of n may refer to retaining every n^{th} sample (e.g. of the data outside of the first data (e.g., data at frequencies below, above or below and above the first frequency range)). Decimation may comprise discarding the remaining samples (e.g. of the data below, above or below and above the first frequency range). It may be that the method comprises decimating the data outside of the first data (e.g., data at frequencies below, above or below and above the first frequency range) by discarding samples thereof to thereby multiply a sampling time or, equivalently, divide a sampling rate of the data outside of the first data (e.g., data at frequencies below, above or below and above the first frequency range) by a decimation factor. It may be that the decimation factor is an integer. It may be that the decimation factor is greater than one. It may be that the processing comprises decimating the data outside of the first data (e.g., data at frequencies below, above or below and above the first frequency range) to a greater extent than the first data, to thereby preserve the signal samples in the portion of the downconverted signal containing the signal information. The first data in the first frequency range may be decimated, but it may be that the first data in the first frequency range is not decimated. It will be understood that data may be discarded, for example, by erasing or overwriting said data.

By decimating the data outside of the first data (e.g., data at frequencies below, above or below and above the first frequency range) in the frequency domain, the sampling frequency of the downconverted frequency domain data is reduced to less than the sampling frequency of the first digital frequency domain data. As illustrated in Fig. 21, the sampling frequency fs of the first digital frequency domain data is reduced to a value fs/R_{factor} where R_{factor} is a sampling frequency reduction factor which depends on the quantity of data decimated.

As mentioned above, it may be that the data points corresponding to the first data are not decimated. It may be that the first data is based on all or substantially all of the information in the first digital frequency domain data relating to the target frequency band. For example, it may be that the first data is based on all (or substantially all, such as at least 90%, at least 95% or at least 99% of the) data points corresponding to the target frequency band from the first signal component 1000, the second signal component 1010 or respective portions thereof.

To inhibit aliasing, the reduced sampling frequency fs/R_{factor} of the downconverted frequency domain data (i.e., reduced compared to the sampling frequency fs of the first digital frequency domain data) may remain greater than or equal to 2BW (if the first frequency of the first frequency range is zero Hz) or greater than or equal to 2BW + 2I_{f} (if the first frequency of the first frequency range is greater than zero Hz by a value I_{f}), where BW is the target bandwidth. If the first frequency of the first frequency range is greater than zero Hz by a value I_{f}, I_{f} may be greater than zero and less than or equal to the difference between half the reduced sampling frequency fs/R_{factor} of the downconverted frequency domain data (i.e., reduced compared to the sampling frequency fs of the first digital frequency domain data) and the target bandwidth of the target frequency band.

The values of the downconverted digital frequency domain data outside of the first data (e.g., data at frequencies below, above or below and above the first frequency range) may be set to zero. The values of the downconverted digital frequency domain data outside of the first data (e.g., data at frequencies below, above or below and above the first frequency range) may be set to zero by way of a filter function (e.g. by way of multiplication in the frequency domain by a filter function). Thus, the downconverted digital frequency domain data outside of the first data (e.g., at frequencies different from the frequencies of the first data, e.g., at frequencies outside of the first frequency range) may comprise or consist of zero valued data points.

As above, an alternative to the above method of reducing the quantity of data points from the first quantity to the second quantity, and thus to reduce the computational and memory requirements of converting the downconverted digital frequency domain data into the time domain, is as follows. The first digital frequency domain data may be provided in a first data array. The processing at 804 may comprise selectively shifting (e.g. selected) data based on the first portion of the first digital frequency domain data corresponding to the target frequency band 1000 to a second data array smaller than the first data array. The data based on the first portion of the first digital frequency domain data may be shifted to the first frequency range of the second data array to provide the downconverted digital frequency domain data. Data based on the first digital frequency domain data outside of the first portion thereof may be discarded. Data outside of the first data (e.g., data at frequencies below, above or below and above the first frequency range) may be provided in the second data array (e.g. to provide the downconverted frequency domain data with a sampling frequency of greater than or equal to 2BW (if the first frequency of the first frequency range is zero Hz) or greater than or equal to 2BW + 2I_{f} (if the first frequency of the first frequency range is greater than zero Hz by a value I_{f}), where BW is the target bandwidth). The values of the data outside of the first data (e.g., data at frequencies below, above or below and above the first frequency range) may be set (e.g. preset) to zero. The values of the data outside of the first data (e.g., data at frequencies below, above or below and above the first frequency range) may be preset to zero or they may be set to zero by way of a filter function (e.g. by way of multiplication in the frequency domain by a filter function). The downconverted digital frequency domain data may be provided with fewer data points than the first digital frequency domain data by the second data array having fewer data points than the first data array. For example, it may be that the quantity of data points of the data outside of the first data (e.g., data at frequencies below, above or below and above the first frequency range) of the downconverted digital frequency domain data is lower than the quantity of data points of the first digital frequency domain data outside of the first portion thereof. The quantity of data points in the first frequency range of the downconverted digital frequency domain data may be the same or substantially the same as (e.g. at least 90%, at least 95% or at least 99% of) the quantity of data points in the first portion of the first digital frequency domain data so as to retain all or substantially all of the signal information in the target frequency band of the first digital frequency domain data.

As above, the first frequency range of the downconverted digital frequency domain data may be at frequencies lower than the target frequency band. The first frequency range may extend from a first frequency to a second frequency. The first frequency may be greater than or equal to zero Hz. The second frequency may be equal to the sum of the first frequency and the bandwidth of the target frequency band. The second frequency may be less than or equal to the sampling frequency of the downconverted digital frequency domain data.

By reducing the number of data points in the downconverted digital frequency domain data as compared to the first digital frequency domain data, the sampling frequency of the downconverted digital frequency domain data is reduced to less than the sampling frequency of the first digital frequency domain data. To inhibit aliasing, the reduced sampling frequency of the downconverted frequency domain data (i.e., reduced compared to the sampling frequency fs of the first digital frequency domain data) may remain greater than or equal to 2BW (if the first frequency of the first frequency range is zero Hz) or greater than or equal to 2BW + 2I_{f} (if the first frequency of the first frequency range is greater than zero Hz by a value I_{f}), where BW is the target bandwidth. If the first frequency of the first frequency range is greater than zero Hz by a value I_{f}, I_{f} may be greater than zero and less than or equal to the difference between half the reduced sampling frequency of the downconverted frequency domain data (i.e., reduced compared to the sampling frequency fs of the first digital frequency domain data) and the target bandwidth of the target frequency band.

As before, it may be that the first portion of the first digital frequency domain data corresponding to the target frequency band 1000 comprises the first digital frequency domain data in the target frequency band 1000 (the first signal component), the first digital frequency domain data in the copy 1010 of the target frequency band folded about half the sampling frequency of the first digital frequency domain data (the second signal component), or portions of the first digital frequency domain data from each of the first and second signal components 1000, 1010 (e.g., together corresponding to the target frequency band).

This method is equivalent to the above described method of generating data comprising first data in a first frequency range and data outside of the first data (e.g., data at frequencies below, above or below and above the first frequency range) and selectively decimating the data outside of the first data (e.g., data at frequencies below, above or below and above the first frequency range) to generate the downconverted digital frequency domain data having fewer data points than the first digital frequency domain data, but is computationally simpler.

In each case, the number of data points in the downconverted digital frequency domain data outside of the first data (e.g., at frequencies different from the frequencies of the first data, e.g., outside of the first frequency range) may be lower than the number of data points of the first digital frequency domain data outside of the first portion thereof. A ratio of a number of data points in the first portion of the first digital frequency domain data to a total number of data points of the first digital frequency domain data may be less than a ratio of a number of data points in the first data of the downconverted digital frequency domain data to a total number of data points of the downconverted digital frequency domain data. A ratio of the number of data points in the first digital frequency domain data in the first portion thereof to a number of data points of the first digital frequency domain data outside of the first portion thereof (e.g., at frequencies different from the frequencies of the first data, e.g., at frequencies outside of the first frequency range) may be less than a ratio of a number of data points in the first data of the downconverted digital frequency domain data to a number of data points of the downconverted digital frequency domain data outside of the first data thereof.

Also in each case, the processing at 804 may comprise performing, for example by the processing circuitry 140, one or more frequency domain multiplications. It may be that the frequency domain multiplications are performed (e.g., selectively) on data based on at least a portion of the first digital frequency domain data, such as data based on the said first portion of the first digital frequency domain data corresponding to the target frequency band. For example, as discussed above, it may be that the processing is to comprise any one or more of the following performed (e.g., by way of frequency domain multiplications) in the frequency domain: filtering; windowing (e.g. by way of a Hanning or Kaiser window function); equalising the effects (e.g. cancelling echo effects) of the communication channel; decoding. The frequency domain multiplications may be performed before or after said frequency shifting of the data based on the at least a portion of the first digital frequency domain data corresponding to the target frequency band. It may therefore be that the data based on the at least a portion of the first digital frequency domain data which is frequency shifted comprises at least a portion of the first digital frequency domain data or at least a portion of the result of frequency domain multiplications performed on at least a portion of data from the first digital frequency domain data (e.g. to perform any one or more of filtering, windowing, equalising the effects of the communication channel on, or decoding the at least a portion of the first digital frequency domain data).

It will be understood that, as discussed above, any two or more functions, such as any two or more of calibration (e.g., equalisation), windowing, decoding and filtering functions, may be combined for applying to the received signal. Thus, it may be that the frequency domain multiplications comprise frequency domain multiplications by a combined function, the combined function comprising any two or more of calibration (e.g., equalisation), windowing, decoding and filtering functions.

As set out above, the processing at 804 may further comprise reducing the quantity of data points from the first quantity of data points of the first digital frequency domain data to the second quantity of data points of the downconverted digital frequency domain data, the second quantity being less than the first quantity (e.g., by decimating data or shifting data to a smaller array as discussed). It may be that the frequency domain multiplications at 804 are performed prior to or after the said reduction in the quantity of data points. It may be that the frequency domain multiplications at 804 are performed prior to or after the said shifting to the second array (where provided). It will be understood that it is more efficient to perform the frequency domain multiplications after the said reduction in the quantity of data points due to the resulting reduction in frequency domain multiplication operations.

At 806, the downconverted digital frequency domain data may be converted into the time domain. For example, the downconverted digital frequency domain data may be converted into the time domain by way of an inverse fast Fourier transform, iFFT, performed thereon.

As above, by the downconverted digital frequency domain data having a reduced number of data points compared to the first digital frequency domain data, the quantity of iFFT processing required to convert the downconverted digital frequency domain data into the time domain at 806 is reduced. By the ratio of a number of data points in the first portion of the first digital frequency domain data to a total number of data points of the first digital frequency domain data may be less than a ratio of a number of data points in the first data of the downconverted digital frequency domain data to a total number of data points of the downconverted digital frequency domain data, the quantity of iFFT processing required to convert the downconverted digital frequency domain data into the time domain at 806 is reduced while retaining the quality of the recovered time domain signal. By discarding data (e.g., data outside of the first portion of the data based on the first digital frequency domain data), memory usage can be reduced.

As above, the downconverted digital frequency domain data may be complex digital frequency domain data (i.e. digital frequency domain data having complex values). In examples comprising reducing the number of data points from a first number in the first digital frequency domain data to a second number in the downconverted digital frequency domain data, it may be that a number of digital frequency domain data points having complex values (i.e. data points of digital frequency domain data having complex values) is reduced from the first number to the second number. In examples comprising discarding samples of digital frequency domain data, it may be that the discarded samples are samples of complex digital frequency domain data (i.e., digital frequency domain data having complex values).

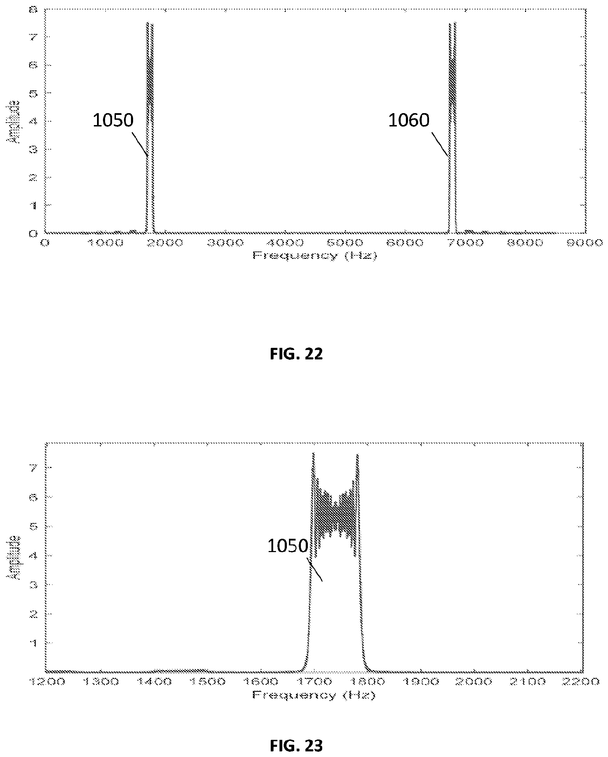

The results shown in Figs. 22-28 demonstrate that first digital frequency domain data can be obtained based on a frequency modulated communication signal, that downconverted digital frequency domain data can be generated from the first digital frequency domain data having fewer data points than the first digital frequency domain data using the above-described method, and that the downconverted digital frequency domain data can be converted into the time domain without significant detriment to the output time domain signal.

Fig. 22 shows, in the frequency domain, an example received communication signal, prior to downconversion, which has been sampled at a sampling frequency of 8522Hz and which has been converted to the frequency domain by FFT. The communication signal comprises a linear chirp sweeping in frequency from 1690Hz to 1790Hz. Accordingly, the spectrum comprises a first component 1050 from 1690Hz to 1790Hz and a second component 1060 from 6732Hz to 6832Hz, the second component 1060 being a copy of the first component 1050 folded about half the sampling frequency. Fig. 23 is a close-up view of the first signal component 1050.

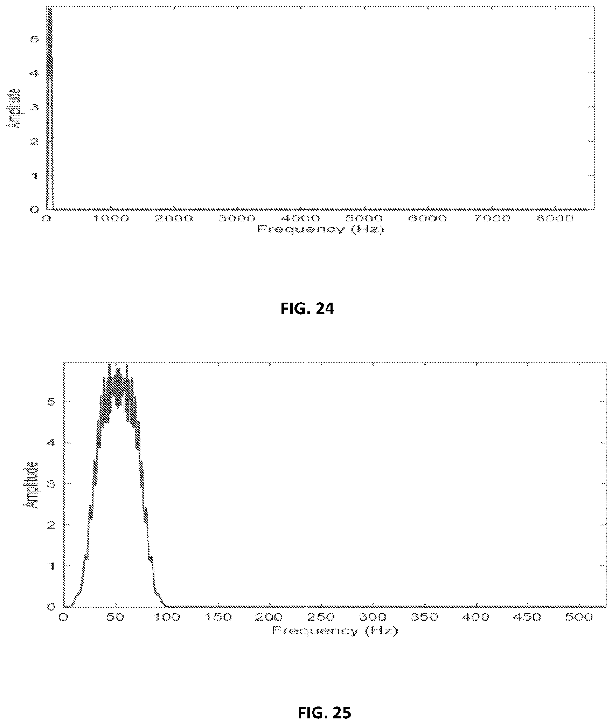

Fig. 24 shows data based on a first portion of the first digital frequency domain data of Fig. 22 corresponding to a target frequency band of the frequency modulated communication signal at 1690Hz to 1790Hz, the data based on the first portion of the first digital frequency domain data having been translated to a first frequency range (2-102Hz). No reduction in the number of data points has been performed, the sampling frequency of the data of Fig. 24 being 8522Hz, the same as the sampling frequency of the first digital frequency domain data of Fig. 22. The data has been filtered, Gaussian windowed and decoded. If the first digital frequency domain data comprises payload data, it may be that the effects of the communication channel thereon have also been equalised based on a calibration function at this stage. In this example, the bandwidth of the target frequency band is 100Hz. However, it will be understood that any suitable bandwidth at any suitable passband may be provided.

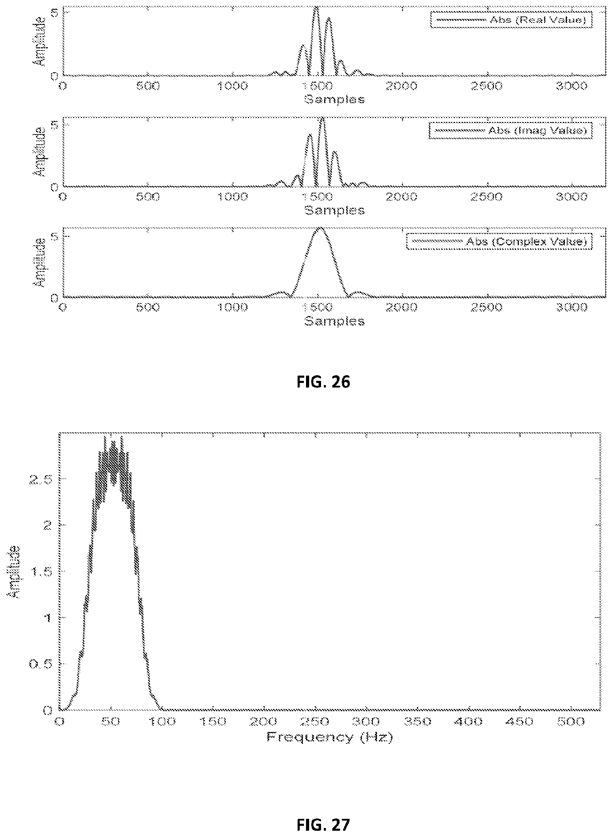

Fig. 25 shows the first frequency range 2-102Hz in more detail. Fig. 26 shows the absolute real (top), imaginary (middle) and complex (bottom) values of the time domain data obtained by converting the frequency domain data of Fig. 25 into the time domain by iFFT, the x axis of Fig. 26 being sample number (rather than time per se).

Fig. 27 shows downconverted digital frequency domain data corresponding to the data of Fig. 25 with the number of samples in the downconverted digital frequency domain data having been reduced by a factor of 16 relative to the first digital frequency domain data of Fig. 22. The full quantity of data points in the first data in the first frequency range 2-102Hz has been retained. As set out above, the data of Fig. 27 may be obtained either by decimating the data outside the first frequency range 2-102Hz in the data of Fig. 25 or by selectively shifting data based on the first portion of the first digital frequency domain data of Fig. 22 corresponding to the target frequency band 1690Hz-1790Hz into a smaller array.

The sampling frequency after the reduction in the number of data points remains greater than twice the bandwidth (100Hz) of the communication signal (and indeed greater than twice the bandwidth summed with twice the frequency offset between zero Hz and the first frequency, 2Hz, of the first frequency range). This helps to ensure that the data within the bandwidth of the communication signal can be recovered from the downconverted digital frequency domain data with little or no aliasing.

It will be understood that the lower the first frequency in the first frequency range of the downconverted digital frequency domain data, the greater the possible reduction in the number of data points compared with the first digital frequency domain data. In some examples, the first frequency may be zero Hz (DC).

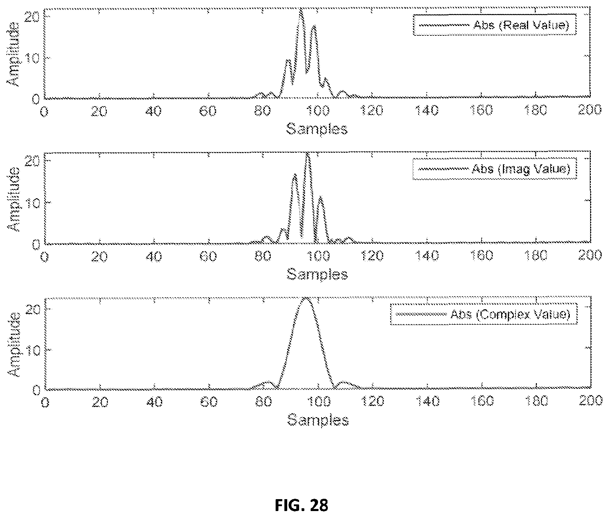

Fig. 28 shows the absolute real (top), imaginary (middle) and complex (bottom) values of the time domain values obtained by converting the frequency domain data of Fig. 27 into the time domain by iFFT, the x axis of Fig. 28 being sample number (rather than time per se). It can be seen that the waveform of Fig. 28 compares favourably to the waveform of Fig. 26, illustrating that the reduction in the number of data points in the downconverted digital frequency domain data is not to the detriment of the output. It can also be seen from the x-axis scales of Figs. 26 and 28 that there are significantly fewer data points in the waveform of Fig. 28, illustrating the computational expense reduction achieved.

It will be understood that the methods described above with reference to Figs. 20-28 may be performed for each of a plurality of selected frequency bands in the received frequency modulated communication signal. In examples where the first digital frequency domain data is provided in a first data array and the processing comprises selectively shifting (e.g. selected) data based on the first portion of the first digital frequency domain data corresponding to a target frequency band to a second data array smaller than the first data array, it will be understood that, when a plurality of target frequency bands of the frequency modulated communication signal are selected for downconversion, it may be that data based on different portions of the first digital frequency domain data corresponding to the different target frequency bands may be shifted to respective arrays, e.g., one per target frequency band. It may be that each of the respective arrays to which different portions of the first digital frequency domain data corresponding to the different target frequency bands are shifted have fewer data points than the first data array, thereby helping to reduce computational expense as discussed above.

As discussed, the frequency modulated communication signal to be received and downconverted may be a payload data signal or a calibration signal (indeed the method for downconverting a frequency modulated signal may be repeated for calibration signals and payload data signals in each of one or more frequency bands) or at least a portion thereof. In either case, it may be desirable to perform (e.g., coarse) energy detection on the time domain data resulting from converting the downconverted digital frequency domain data into the time domain in order to determine whether a signal is present and data relating to the signal should be stored, for example for further processing, or whether no calibration or payload data signal is present such that the data should be discarded. For example, it may be that data based on received calibration or payload data signals is stored for later processing (rather than further processed immediately) to free the receiving node (e.g., apparatus 700 of receiving node) to receive further calibration or payload data signals shortly after the received calibration or payload data signals. The apparatus 700 may then further process the data relating to the calibration or payload data signals later based on the stored data.

It may be that calibration signals are transmitted by the transmitting node, and received by the receiving node, prior to payload data signals. It may be that, in order to detect a calibration signal in a target frequency band, the receiving node (e.g. the apparatus 700 of the receiving node) is to successively capture received signals over a series of limited time windows. For each of the time windows, signals in the target frequency band may be converted into first digital frequency domain data (e.g., by sampling and FFT operations), processed to provide downconverted digital frequency domain data and converted into the time domain by any of the methods described herein. Energy detection may then be run on the resulting downconverted time domain data to determine whether a signal is present. If a signal is present in the time window, it may be assumed that the signal is a calibration signal, and data relating to the signal may be stored in a memory. If a signal is not present in the time window, the data relating to the time window may be discarded.

If no energy relating to the target frequency band has yet been detected, the receiving node (e.g. apparatus 700) may capture signals in successive time windows until a signal is detected in the target frequency band. It may be that, following the time window in which a signal is first detected in the target frequency band, the receiving node (e.g. apparatus 700) is to capture signals in one or more further time windows. Data relating to the time window in which the signal was first detected and data relating to the said following time window(s) may be combined to provide combined data for the target frequency band. The number of time windows may be predetermined; alternatively, after the time window in which the signal was first detected, the method may be repeated for one or more additional time windows until no signals are detected in the target frequency band. This helps to avoid missing part of a signal which may for example span more than one time window.

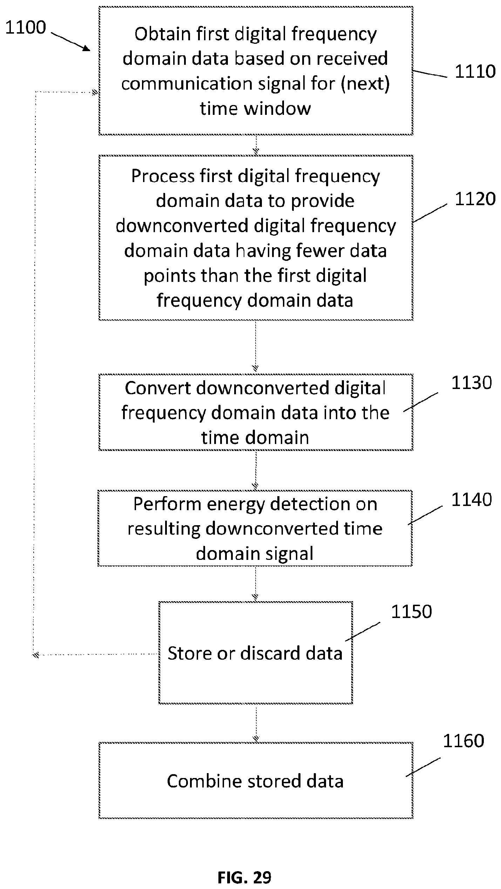

For example, an apparatus of the receiving node (such as apparatus 700) may perform the method 1100 illustrated by the flow diagram of Fig. 29. Blocks 1110-1130 may be performed in accordance with any of the examples discussed herein with respect to blocks 802-806 of Fig. 11 for signals captured in a respective time window n for a target frequency band. At block 1140, (e.g., coarse) energy detection may be performed on the downconverted time domain data generated in block 1130 for that time window. If no energy is detected in the target frequency band, the data relating to that time window may be discarded at block 1150. If no energy relating to a calibration signal has yet been detected in the target frequency band, the method may proceed from block 1150 back to block 1110 and blocks 1110-1140 may be repeated for successive time windows until energy relating to a calibration signal is detected in the target frequency band. If energy is detected at block 1140, data relating to that time window may be stored for further processing at block 1150.

In some examples, at block 1150, n may be incremented. If n is less than a predetermined limit, the method may return to block 1110 and blocks 1110-1150 may be repeated for the next time window. If n is equal to the limit, rather than repeating blocks 1110-1150 for another time window, the method may move to block 1160.

Alternatively, if energy relating to a calibration signal is detected at block 1140, the method may return to block 1110 (e.g., without performing a comparison of a window number n against a predetermined limit) and blocks 1110-1150 may be repeated for the next time window. If no energy relating to a calibration signal is detected in the target frequency band at block 1140 for a particular time window (after the time window in which energy relating to a calibration signal was first detected in the target frequency band), rather than repeating blocks 1110-1150 for another time window, the method may move to block 1160.

At block 1160, data relating to the first time window in which energy relating to a calibration signal was detected in the target frequency band and data relating to one or more additional time windows in which energy relating to a calibration signal was detected in the target frequency band may be combined to provide combined data relating to the target frequency band.

At block 1150, it may be that the data relating to the time window which is stored is the downconverted time domain data relating to that time window. In this case, block 1160 may comprise concatenating the downconverted time domain data from the different time windows and storing the concatenated data. It may be that the downconverted frequency domain data generated in block 1120 is discarded (e.g., the memory used to store the downconverted frequency domain data generated in block 1120 may be used to store the downconverted time domain data generated in block 1130).

Alternatively, it may be that the data relating to the time window which is stored in block 1150 is the (e.g., complex) downconverted frequency domain data relating to that time window generated in block 1120. In this case in block 1160, it may be that the downconverted digital frequency domain data generated in block 1120 for different time windows is combined in the frequency domain by applying appropriate phase corrections to the signals obtained in the different windows and the combined downconverted digital frequency domain data may be stored. Alternatively, frequency domain data for respective time windows may be stored separately. It may be that downconverted time domain data obtained in block 1130 is discarded after (e.g., coarse) energy detection.

It may be that the method of Fig. 29 is repeated for one or more other target frequency bands. For example, as discussed above, if a plurality of frequency bands are being used for communications, calibration signals in different frequency bands may be transmitted at different times from each other. In this case, it may be that the downconverted digital frequency domain data or the downconverted time domain data for the different target frequency bands may be combined to provide combined downconverted digital frequency domain data or combined (e.g., concatenated) downconverted time domain data relating to the plurality of target frequency bands. The combined downconverted digital frequency domain data or combined downconverted time domain data may be stored.

The time domain data resulting from the conversion of the downconverted frequency domain data into the time domain may have complex (i.e., real and imaginary) values. Accordingly, storing the downconverted time domain data in block 1150 (or the combined time domain data generated in block 1160) may use a relatively large amount of memory. In downhole applications, available memory may be limited. In some examples, the complex values of the downconverted time domain data may be stored. However, in the method for downconverting a frequency modulated communication signal described above with reference to Figs. 20-28, memory usage for storing the time domain data may be reduced by selectively storing one of the real and imaginary values of the time domain data (e.g., the time domain data for a particular target frequency band or for a plurality of target frequency bands) and selectively discarding the other one of the real and imaginary values of the time domain data.

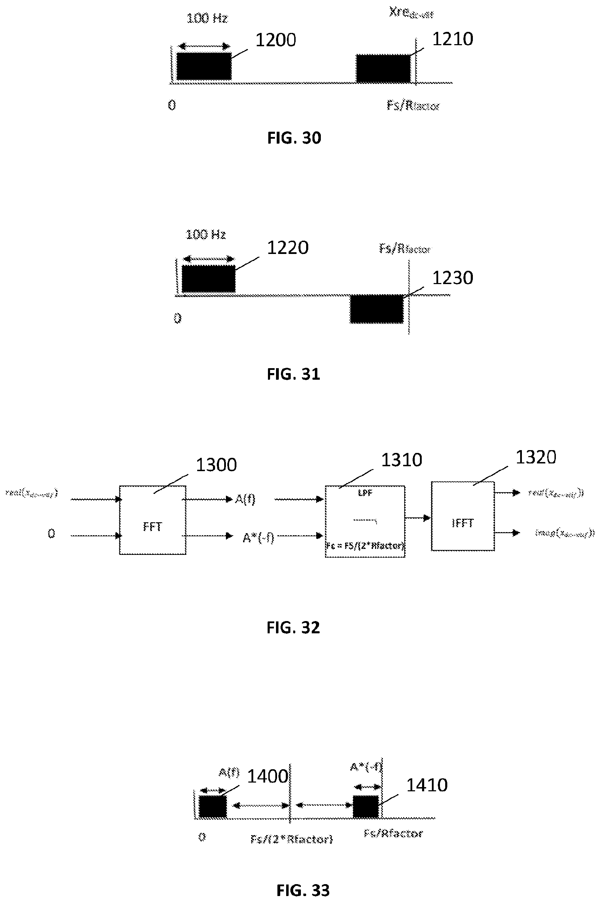

As set out above, the reduced sampling frequency of the downconverted frequency domain data (i.e., reduced compared to the sampling frequency fs of the first digital frequency domain data) may remain greater than or equal to 2BW (if the first frequency of the first frequency range is zero Hz) or greater than or equal to 2BW + 2I_{f} (if the first frequency of the first frequency range is greater than zero Hz by a value I_{f}), where BW is the target bandwidth, where I_{f} is less than or equal to the difference between half the reduced sampling frequency of the downconverted frequency domain data (i.e., reduced compared to the sampling frequency fs of the first digital frequency domain data) and the target bandwidth of the target frequency band. By I_{f} being greater than or equal to zero Hz and less than or equal to the difference between half the reduced sampling frequency of the downconverted digital frequency domain data and the target bandwidth, a symmetry is provided about half the reduced sampling frequency in the spectra of the real and imaginary parts of the time domain data resulting from the conversion of the downconverted frequency domain data into the time domain, allowing the other of the real and imaginary parts (and thus the complex values) of the time domain data to be generated (e.g., regenerated) from the selectively stored one of the real and imaginary parts, for example by way of Hilbert transform operations. This is discussed in more detail below with reference to Figs. 30-37.

Fig. 30 illustrates a spectrum of real values of complex time domain data resulting from the conversion of downconverted digital frequency domain data to the time domain (e.g., by iFFT as discussed), the spectrum of the real values having data 1200 in the first frequency range and a folded copy 1210 of the data 1200 folded about half the reduced sampling frequency fₛ/R_{factor} of the time domain data (which is the same as the reduced sampling frequency fₛ/R_{factor} of the downconverted digital frequency domain data). The folded copy 1210 is the hermetian symmetry of data 1200. The amplitudes of the real values of the spectrum 1200 and the folded copy 1210 of the real values are identical. Fig. 31 illustrates a spectrum of imaginary values of the complex time domain data resulting from the conversion of the downconverted digital frequency domain data to the time domain (e.g., by iFFT as discussed), the spectrum of the imaginary values having data 1220 in the first frequency range and a folded copy 1230 of the data 1220 folded about half the reduced sampling frequency fₛ/R_{factor} of the time domain data (which is the same as the reduced sampling frequency fₛ/R_{factor} of the downconverted digital frequency domain data). Folded copy 1230 is the negative hermetian symmetry of data 1220. The amplitudes of the imaginary data 1220 in the first frequency range are positive, whilst amplitudes of the folded copy 1230 of the imaginary data 1220 are of the same magnitude as the amplitudes of the data 1220 in the first frequency range but negative rather than positive. Other than the folded copy 1230 of the data 1220 having negative rather than positive amplitudes, the spectra of both the real and imaginary parts of the complex time domain data are symmetrical about half the sampling frequency fₛ/R_{factor}. It will be understood that the combination (sum) of the spectra of Figs. 30 and 31 is the spectrum of complex values of the complex time domain data resulting from the conversion of downconverted digital frequency domain data to the time domain.

The hermetian symmetry of the spectra of Figs. 30 and 31 allows a selected one (which may be either one) of real and imaginary parts of the complex time domain data to be stored in memory, and for the other of the real and imaginary parts of the complex time domain data to be discarded, thereby reducing by half the memory used by storing the selected data. This is because, as mentioned above, the other of the real and imaginary parts (and thus the complex values) of the time domain data can be generated (e.g., regenerated) from the selectively stored one of the real and imaginary parts, for example by way of Hilbert transform operations. An example process for (re)generating the other of the real and imaginary parts of the time domain data from the selectively stored one of the real and imaginary parts is illustrated in Fig. 32.

As shown in Fig. 32, the unstored one of the real and imaginary parts (and thus the complex values) of the time domain data can be generated from the selectively stored one of the real and imaginary parts of the time domain data by converting the stored one of the real and imaginary parts of the time domain data into the frequency domain, for example by way of FFT block 1300. The outputs of the FFT block A(f) 1400 and A*(-f) 1410 (A*(-f) being the hermetian symmetry of A(f)) are illustrated in Fig. 33. The amplitudes of A(f) 1400 and A*(-f) 1410 are half of the corresponding complex value amplitudes of the spectrum of complex time domain data from which the stored one of the real and imaginary parts are taken. It can be seen from Fig. 33 that A(f) is provided in the first frequency range and A*(-f) 1410 is provided in a frequency range based on the first frequency range folded about half the sampling frequency fₛ/R_{factor} of the time domain data (which is the same as the reduced sampling frequency fₛ/R_{factor} of the downconverted digital frequency domain data).

The output of the FFT block 1300 is input to a low pass filter 1310. The low pass filter 1310 may remove the folded copy A*(-f) 1410 of the data A(f) 1400 and allow the data A(f) 1400 to pass through. The low pass filter 1310 may have an upper cut-off frequency of fₛ/2R_{factor}, i.e., half the reduced sampling frequency of the downconverted time domain data. The output of the low pass filter 1310 is converted back to the time domain, for example by way of an iFFT block 1320. The output of the iFFT block 1320 comprises both the real and imaginary parts of the time domain data. It will be understood that the amplitudes of A(f) and A*(-f) being half of the corresponding complex value amplitudes of the spectrum of the complex time domain data can also be compensated for in the operations illustrated in Fig. 32.

Although Fig. 32 shows the input to the FFT block 1300 being the (stored) real value of the time domain data, and the imaginary part of the time domain data input to the FFT block 1300 being zero, it will be understood that the same result can be achieved by inputting the (stored) imaginary part of the time domain data to the FFT block 1300 and inputting a zero valued real part to the FFT block 1300. Thus, either real or imaginary values of the downconverted time domain data may be selectively stored and equivalently used to generate the complex values.

The operations illustrated in Fig. 32 amount to performing a Hilbert transform on the stored one of the real and imaginary parts of the time domain data.

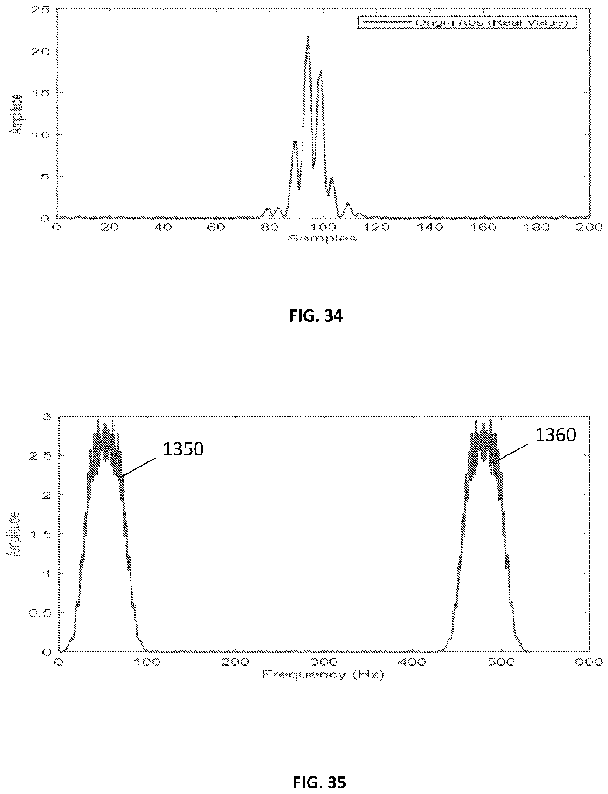

An example implementation of the process illustrated by Figs. 30 to 33 is now described with reference to the waveforms of Figs. 34 to 37. The waveforms of Figs. 34 to 37 are based on the signals of Figs. 22-28 discussed above. Fig. 34 is a zoomed in version showing the top waveform of Fig. 28, which shows the real values of time domain data obtained by converting the downconverted digital frequency domain data of Fig. 27 into the time domain. The real values may be stored in memory (e.g., without the imaginary values). The real values of the time domain data are input to an FFT block, such as FFT block 1300. The output of the FFT block is illustrated in Fig. 35, which is equivalent to the signal shown in Fig. 33, having data 1350 (equivalent to data 1400) in a first frequency range and a copy 1360 (equivalent to copy 1410) folded about half the sampling frequency. The output of the FFT block is input to a low pass filter, such as low pass filter 1310, having an upper cut-off frequency of fₛ/2R_{factor}, i.e., half the reduced sampling frequency of the downconverted frequency domain data, which removes folded copy 1360 and allows data 1350 to pass through. The output of the low pass filter, comprising data 1350, is shown in Fig. 36. The output of the low pass filter is converted back to the time domain, for example by way of an iFFT block 1320. As shown in the upper part of Fig. 37, which shows the absolute values of the imaginary part of the time domain data, the imaginary part of the time domain data has been generated. The lower part of Fig. 37 shows the absolute complex value of the time domain data taking into account the generated imaginary part.

Thus, the unstored one of the real and imaginary values of the time domain data can be generated from the stored one of the real and imaginary values, enabling a selected one of the real and imaginary values to be stored (rather than both), thereby reducing (halving) the memory storage requirements for the time domain data.

Fig. 38 illustrates a method of generating a calibration function for equalising the effects of the communication channel on a payload data signal.

A calibration signal may be detected and processed (e.g., downconverted) as described herein. The calibration signal may be a calibration signal as discussed above. For example it may be that the calibration signal comprises calibration data encoded based on a respective code. The calibration data may comprise a constant or time varying amplitude.

The calibration data may be known by the apparatus 700 (e.g., stored in a memory in communication with the processing circuitry thereof). The calibration function may be based on data derived from the calibration signal. In some examples, processing the calibration signal may comprise decoding the calibration signal (e.g., in the frequency domain, as discussed herein). The calibration function may be based on the decoded calibration signal. For example the calibration signal may be decoded in any of the ways mentioned above for the decoding of the communication signal, such as by multiplying the calibration signal by a reference signal based on a complex conjugate of a code in respect of which the calibration signal is encoded. In this case, it may be that the calibration function is determined based on the decoded calibration signal.

As discussed above, at block 1150 of the method of Fig. 29, when calibration signals are detected, it may be that the data stored after data capture and downconversion is downconverted time domain data or it may be that the data stored is downconverted frequency domain data. As also discussed above, in the former case, it may be that a selected one of the real and imaginary values of complex downconverted time domain data is stored.

As illustrated in Fig. 38, when the captured and downconverted data stored relating to a calibration signal is a selected one of the real and imaginary values of complex time domain data relating to the calibration signal, the stored real or imaginary values of the downconverted (and in some examples decoded) time domain data may be obtained (e.g., retrieved from memory) in block 1510 and the complex values of the downconverted (and in some examples decoded) time domain data may be generated (e.g., regenerated) at block 1520 based on the stored real or imaginary values of the downconverted (and in some examples decoded) time domain data, for example using the Hilbert transform operations discussed above with respect to Fig. 32. Blocks 1510 and 1520 may be omitted, for example if the data stored is the (e.g., complex) downconverted frequency domain data. In this case, the (e.g., complex) downconverted frequency domain data based on the received calibration signal may be obtained and converted to the time domain (and, if the downconverted frequency domain data from different time windows has not been combined (e.g., is stored separately), the time domain data for the respective time windows may be concatenated in the time domain). Blocks 1510 and 1520 may also be omitted if the complex values of the time domain downconverted (and in some cases decoded) data based on the calibration signal are stored in the memory. In this case, the complex values of the time domain downconverted (and in some cases decoded) data based on the calibration signal are obtained from memory.

The time domain downconverted data obtained in any of the above ways may be input to block 1530. The time domain downconverted data input to block 1530 may comprise complex values of time domain downconverted data relating to the calibration signal in the target frequency band. The time domain downconverted data input to block 1530 may comprise complex values of time domain downconverted data relating to calibration signals in the target frequency band and one or more additional target frequency bands. For example, as discussed above with respect to Fig. 29, data relating to calibration signals in a plurality of target frequency bands may have been combined.

At block 1530, (e.g., fine) energy detection may be performed on the complex time domain downconverted (and in some cases decoded) data to accurately determine the starting point of the data relating to the calibration signal for the target frequency band (or for a respective one of the target frequency bands). For example, calibration signals relating to different frequency bands may be transmitted and received in a known sequence, allowing the starting point of the data relating to the calibration signal for the target frequency band to be determined. Data relating to the calibration signal for the target frequency band (or for a respective one of the target frequency bands) may be selected from the complex time domain downconverted (and in some cases decoded) data based on the determined starting point.

At block 1540, the complex time domain downconverted (and in some cases decoded) data relating to the calibration signal for the target frequency band may be converted to the frequency domain, for example by way of an FFT, to provide complex downconverted frequency domain data relating to the calibration signal for the target frequency band. The complex time domain downconverted (and in some cases decoded) data relating to the target frequency band for the target frequency band may then be erased or overwritten.

At block 1550, the calibration function for the target frequency band may be determined based on the (complex) downconverted (and in some cases decoded) frequency domain data relating to the calibration signal for that band, for example in the frequency domain, for example by obtaining an inverse of the calibration data in the frequency domain, for example by obtaining the inverse of the magnitude and the complex conjugate of the phase of the frequency domain version of the downconverted (and in some cases decoded) calibration data. The calibration function may then be stored in the frequency domain for multiplying with a payload data signal in the target frequency band converted into the frequency domain in order to equalise the effects of the communication signal thereon. The receiving node (e.g., apparatus 700) may be to equalise the effects of the communication channel on a received payload data signal based on the stored calibration function.

It will be understood that, as discussed above, the calibration function may be combined with other functions such as any one or more of windowing, decoding and filtering functions for applying to the received payload data signal (e.g., by frequency domain multiplications). Thus, the calibration function may be applied to data based on the received payload signal, for example in a combined function with (or in a sequence with) one or more other functions such as any one or more of windowing, decoding, filtering.

Blocks 1530-1550 of Fig. 38 may be repeated to determine calibration functions for each of a plurality of target frequency bands. For example, as discussed above, the transmitting node may transmit calibration signals for different target frequency bands in a sequence known to the receiving node and the receiving node may attempt to downconvert data for each of the target frequency bands based on the known sequence, for example to detect the calibration signals for the different bands. The receiving node (e.g., apparatus 700) may be to equalise the effects of the communication channel on a received payload data signal in each of the plurality of target frequency bands based on the calibration function determined for the respective band.

Although in some examples disclosed herein the downconverted digital frequency domain data is provided either by decimating data or selectively shifting data to a smaller array, it will be understood that, in other examples, the downconverted digital frequency domain data may be stored in an array of digital frequency domain data comprising the downconverted digital frequency domain data (for conversion into the time domain) and other digital frequency domain data (such as zero valued digital frequency domain data). For example, the downconverted digital frequency domain data may be provided in an array of the same size as the array storing the first digital frequency domain data. The downconverted digital frequency domain data may be identified, for example, by any one or more of its position in the array, its frequency values and the configuration (e.g., of the iFFT operations) of which data from the array is to be selected for conversion to the time domain (e.g., the downconverted digital frequency domain data may be stored in the locations of the array which the iFFT operations are configured to select for conversion to the time domain).

The apparatus 700 may be to selectively obtain (or the methods of Figs. 11 and 30 may comprise selectively obtaining) the downconverted digital frequency domain data from the array for conversion into the time domain, and to selectively convert the downconverted digital frequency domain data into the time domain. For example, the apparatus 700 may be to selectively perform (or the methods of Figs. 11 and 30 may comprise selectively performing) iFFT operations on the digital downconverted frequency domain data and not the other frequency domain data. It will be understood that the downconverted digital frequency domain data, selectively obtained from the array, may still have fewer data points than the first digital frequency domain data. For example, the downconverted digital signal frequency domain data may be the same downconverted digital signal frequency domain data as that provided in the examples disclosed herein which comprise decimating data or selectively shifting data to a smaller array. Thus, although in such an alternative implementation it may be that memory usage is not reduced, the downconverted digital frequency domain data, selectively obtained from the array, having fewer data points than the first digital frequency domain data still helps to reduce the computational overhead of converting the downconverted digital frequency domain data to the time domain.

In the examples discussed herein, the (e.g., processing circuitry of) apparatus 700 may be to selectively convert (and the methods of Figs. 11 and 30 may comprise selectively converting) the downconverted digital frequency domain data into the time domain, for example by converting the downconverted digital frequency domain data obtained after decimation to the time domain, converting the downconverted digital frequency domain data from the smaller array to the time domain or by selectively obtaining the downconverted digital frequency domain data from a larger array (i.e., from an array comprising the downconverted digital frequency domain data and the other digital frequency domain data) and converting the selectively obtained downconverted digital frequency domain data to the time domain. In each of the examples discussed herein, this helps to reduce the processing overhead of converting between the frequency and time domains, for example compared to converting data having the same number of data points as (or a greater number of data points than) the first digital frequency domain data. In examples which involve reducing the quantity of data points (e.g., by decimation or by shifting digital frequency domain data from a larger array to a smaller array), for example such that an array comprising the downconverted digital frequency domain data has fewer data points than an array comprising the first digital frequency domain data, memory usage is also reduced.

The scope of protection of the invention is limited by the appended claims.

## Claims

1. Apparatus (700) for downconverting a received frequency modulated communication signal, the apparatus (700) comprising processing circuitry (140) to:
obtain first digital frequency domain data based on the received frequency modulated communication signal;
process the first digital frequency domain data in the frequency domain to provide downconverted digital frequency domain data, wherein the processing is to comprise frequency shifting data based on at least a portion of the first digital frequency domain data, wherein the downconverted digital frequency domain data has fewer data points than the first digital frequency domain data; and
convert the downconverted digital frequency domain data into the time domain;
wherein the processing is to comprise reducing a quantity of data points from a first quantity of data points in the first digital frequency domain data to a second quantity of data points in the downconverted digital frequency domain data, the second quantity being less than the first quantity.

2. The apparatus (700) of claim 1 wherein the downconverted digital frequency domain data comprises first and second data in respective first and second frequency ranges, the first data being based on a first portion of the first digital frequency domain data corresponding to a first portion of a target frequency band of the frequency modulated communication signal and the second data being based on a second portion of the first digital frequency domain data corresponding to a second portion of the target frequency band of the frequency modulated communication signal.

3. The apparatus (700) of claim 2 wherein the said processing is to comprise discarding data, the discarded data being based on at least a portion of the first digital frequency domain data outside of the first and second portions thereof.

4. The apparatus (700) of claim 2 or claim 3 wherein the first and second data are based on all or substantially all of the information in the first digital frequency domain data relating to the target frequency band.

5. The apparatus (700) of any one of claims 2 to 4 wherein the downconverted digital frequency domain data further comprises intermediate data in an intermediate frequency range between the first and second frequency ranges.

6. The apparatus (700) of claim 5 wherein the number of data points in the intermediate data of the downconverted digital frequency domain data is lower than the number of data points of the first digital frequency domain data outside of the first and second portions thereof.

7. The apparatus (700) of claim 5 or claim 6 wherein a ratio of a number of data points of the first digital frequency domain data in the combination of the first and second portions thereof to a number of data points of the first digital frequency domain data outside of the first and second portions thereof is less than a ratio of a number of data points in the combination of the first and second data of the downconverted digital frequency domain data to a number of data points of the intermediate data of the downconverted digital frequency domain data.

8. The apparatus (700) of any one of claims 5 to 7 wherein the intermediate data comprises or consists of zero valued data points.

9. The apparatus (700) of any one of claims 2 to 8 wherein a ratio of a number of data points of the first digital frequency domain data in the combination of the first and second portions thereof to a total number of data points of the first digital frequency domain data is less than a ratio of a number of data points in the combination of the first and second data of the downconverted digital frequency domain data to a total number of data points of the downconverted digital frequency domain data.

10. The apparatus (700) of any one of claims 2 to 9 wherein the target frequency band consists of the first and second portions thereof.

11. The apparatus (700) of any preceding claim wherein the apparatus (700) is for downhole communications.

12. A method of downconverting a received frequency modulated communication signal, the method is implemented by an apparatus and comprising:
obtaining (802) first digital frequency domain data based on the received frequency modulated communication signal;
processing (804) the first digital frequency domain data in the frequency domain to provide downconverted digital frequency domain data, the processing comprising frequency shifting data based on at least a portion of the first digital frequency domain data, wherein the downconverted digital frequency domain data has fewer data points than the first digital frequency domain data; and
converting (806) the downconverted digital frequency domain data into the time domain;
wherein the said processing comprises reducing a quantity of data points from a first quantity of data points in the first digital frequency domain data to a second quantity of data points in the downconverted digital frequency domain data, the second quantity being less than the first quantity.

13. A communications node comprising apparatus (700) of any of claims 1 to 11 .

14. A computer program product comprising computer program instructions for causing processing circuitry to perform in accordance with the processing circuitry (140) of the apparatus (700) according to any of claims 1 to 11.

15. A non-transitory computer readable medium comprising executable instructions for causing processing circuitry to perform in accordance with the processing circuitry (140) of the apparatus (700) according to any of claims 1 to 11.

## Patentansprüche

1. Vorrichtung (700) zur Abwärtskonvertierung eines empfangenen frequenzmodulierten Kommunikationssignals, wobei die Vorrichtung (700) Verarbeitungsschaltung (140) zu Folgendem umfasst:
Erhalten von ersten digitalen Frequenzdomänendaten basierend auf dem empfangenen frequenzmodulierten Kommunikationssignal;
Verarbeiten der ersten digitalen Frequenzdomänendaten in der Frequenzdomäne, um abwärtskonvertierte digitale Frequenzdomänendaten bereitzustellen, wobei das Verarbeiten Frequenzverschieben von Daten basierend auf zumindest einem Teil der ersten digitalen Frequenzdomänendaten umfassen soll, wobei die abwärtskonvertierten digitalen Frequenzdomänendaten weniger Datenpunkte als die ersten digitalen Frequenzdomänendaten aufweisen; und
Konvertieren der abwärtskonvertierten digitalen Frequenzdomänendaten in die Zeitdomäne;
wobei das Verarbeiten Reduzieren einer Menge von Datenpunkten von einer ersten Menge von Datenpunkten in den ersten digitalen Frequenzdomänendaten auf eine zweite Menge von Datenpunkten in den abwärtskonvertierten digitalen Frequenzdomänendaten umfassen soll, wobei die zweite Menge weniger als die erste Menge ist.

2. Vorrichtung (700) nach Anspruch 1, wobei die abwärtskonvertierten digitalen Frequenzdomänendaten erste und zweite Daten in jeweiligen ersten und zweiten Frequenzbereichen umfassen, wobei die ersten Daten auf einem ersten Teil der ersten digitalen Frequenzdomänendaten entsprechend einem ersten Teil eines Zielfrequenzbands des frequenzmodulierten Kommunikationssignals basieren und die zweiten Daten auf einem zweiten Teil der ersten digitalen Frequenzdomänendaten entsprechend einem zweiten Teil des Zielfrequenzbands des frequenzmodulierten Kommunikationssignals basieren.

3. Vorrichtung (700) nach Anspruch 2, wobei das Verarbeiten Verwerfen von Daten umfassen soll, wobei die verworfenen Daten auf zumindest einem Teil der ersten digitalen Frequenzdomänendaten außerhalb des ersten und des zweiten Teils davon basieren.

4. Vorrichtung (700) nach Anspruch 2 oder Anspruch 3, wobei die ersten und die zweiten Daten auf allen oder im Wesentlichen allen der Informationen in den ersten digitalen Frequenzdomänendaten basieren, die sich auf das Zielfrequenzband beziehen.

5. Vorrichtung (700) nach einem der Ansprüche 2 bis 4, wobei die abwärtskonvertierten digitalen Frequenzdomänendaten ferner Zwischendaten in einem Zwischenfrequenzbereich zwischen dem ersten und dem zweiten Frequenzbereich umfassen.

6. Vorrichtung (700) nach Anspruch 5, wobei die Anzahl an Datenpunkten in den Zwischendaten der abwärtskonvertierten digitalen Frequenzdomänendaten niedriger als die Anzahl an Datenpunkten der ersten digitalen Frequenzdomänendaten außerhalb des ersten und des zweiten Teils davon ist.

7. Vorrichtung (700) nach Anspruch 5 oder Anspruch 6, wobei ein Verhältnis einer Anzahl an Datenpunkten der ersten digitalen Frequenzdomänendaten in der Kombination des ersten und des zweiten Teils davon zu einer Anzahl an Datenpunkten der ersten digitalen Frequenzdomänendaten außerhalb des ersten und des zweiten Teils davon weniger als ein Verhältnis einer Anzahl an Datenpunkten in der Kombination der ersten und der zweiten Daten der abwärtskonvertierten digitalen Frequenzdomänendaten zu einer Anzahl an Datenpunkten der Zwischendaten der abwärtskonvertierten digitalen Frequenzdomänendaten ist.

8. Vorrichtung (700) nach einem der Ansprüche 5 bis 7, wobei die Zwischendaten nullwertige Datenpunkte umfassen oder daraus bestehen.

9. Vorrichtung (700) nach einem der Ansprüche 2 bis 8, wobei ein Verhältnis einer Anzahl an Datenpunkten der ersten digitalen Frequenzdomänendaten in der Kombination des ersten und des zweiten Teils davon zu einer Gesamtanzahl an Datenpunkten der ersten digitalen Frequenzdomänendaten weniger als ein Verhältnis einer Anzahl an Datenpunkten in der Kombination der ersten und der zweiten Daten der abwärtskonvertierten digitalen Frequenzdomänendaten zu einer Gesamtanzahl an Datenpunkten der abwärtskonvertierten digitalen Frequenzdomänendaten ist.

10. Vorrichtung (700) nach einem der Ansprüche 2 bis 9, wobei das Zielfrequenzband aus dem ersten und dem zweiten Teil davon besteht.

11. Vorrichtung (700) nach einem vorhergehenden Anspruch, wobei die Vorrichtung (700) für Untertagekommunikation ist.

12. Verfahren zur Abwärtskonvertierung eines empfangenen frequenzmodulierten Kommunikationssignals, wobei das Verfahren durch eine Vorrichtung implementiert wird und Folgendes umfasst:
Erhalten (802) von ersten digitalen Frequenzdomänendaten basierend auf dem empfangenen frequenzmodulierten Kommunikationssignal;
Verarbeiten (804) der ersten digitalen Frequenzdomänendaten in der Frequenzdomäne, um abwärtskonvertierte digitale Frequenzdomänendaten bereitzustellen, wobei das Verarbeiten Frequenzverschieben von Daten basierend auf zumindest einem Teil der ersten digitalen Frequenzdomänendaten umfassen soll, wobei die abwärtskonvertierten digitalen Frequenzdomänendaten weniger Datenpunkte als die ersten digitalen Frequenzdomänendaten aufweisen; und
Konvertieren (806) der abwärtskonvertierten digitalen Frequenzdomänendaten in die Zeitdomäne;
wobei das Verarbeiten Reduzieren einer Menge von Datenpunkten von einer ersten Menge von Datenpunkten in den ersten digitalen Frequenzdomänendaten auf eine zweite Menge von Datenpunkten in den abwärtskonvertierten digitalen Frequenzdomänendaten umfasst, wobei die zweite Menge weniger als die erste Menge ist.

13. Kommunikationsknoten, umfassend Vorrichtung (700) nach einem der Ansprüche 1 bis 11.

14. Computerprogrammprodukt, umfassend Computerprogrammanweisungen, um zu bewirken, dass Verarbeitungsschaltung in Übereinstimmung mit der Verarbeitungsschaltung (140) der Vorrichtung (700) gemäß einem der Ansprüche 1 bis 11 durchgeführt wird.

15. Nichtflüchtiges computerlesbares Medium, das ausführbare Anweisungen umfasst, um zu bewirken, dass Verarbeitungsschaltung in Übereinstimmung mit der Verarbeitungsschaltung (140) der Vorrichtung (700) gemäß einem der Ansprüche 1 bis 11 durchgeführt wird.

## Revendications

1. Appareil (700) destiné à la conversion descendante d'un signal de communication reçu modulé en fréquence, l'appareil (700) comprenant un montage de circuits de traitement (140) pour :
obtenir des premières données numériques de domaine fréquentiel sur la base du signal de communication reçu modulé en fréquence ;
traiter les premières données numériques de domaine fréquentiel dans le domaine fréquentiel pour fournir des données numériques de domaine fréquentiel converties dans le sens descendant, ledit traitement devant comprendre le décalage de fréquence de données sur la base d'au moins une partie des premières données numériques de domaine fréquentiel, lesdites données numériques de domaine fréquentiel converties dans le sens descendant possédant moins de points de données que les premières données numériques de domaine fréquentiel ; et
convertir les données numériques de domaine fréquentiel converties dans le sens descendant dans le domaine temporel ;
ledit traitement devant comprendre la réduction d'une quantité de points de données d'une première quantité de points de données dans les premières données numériques de domaine fréquentiel à une seconde quantité de points de données dans les données numériques de domaine fréquentiel converties dans le sens descendant, la seconde quantité étant inférieure à la première quantité.

2. Appareil (700) de la revendication 1, lesdites données numériques de domaine fréquentiel converties dans le sens descendant comprenant des premières et secondes données dans des première et seconde plages de fréquences respectives, les premières données étant basées sur une première partie des premières données numériques de domaine fréquentiel correspondant à une première partie d'une bande de fréquences cible du signal de communication modulé en fréquence et les secondes données étant basées sur une seconde partie des premières données numériques de domaine fréquentiel correspondant à une seconde partie de la bande de fréquences cible du signal de communication modulé en fréquence.

3. Appareil (700) de la revendication 2, ledit traitement devant comprendre le rejet de données, les données rejetées étant basées sur au moins une partie des premières données numériques de domaine fréquentiel en dehors des première et seconde parties de celles-ci.

4. Appareil (700) de la revendication 2 ou de la revendication 3, lesdites premières et secondes données étant basées sur la totalité ou sensiblement la totalité des informations dans les premières données numériques de domaine fréquentiel relatives à la bande de fréquences cible.

5. Appareil (700) de l'une quelconque des revendications 2 à 4, lesdites données numériques de domaine fréquentiel converties dans le sens descendant comprenant en outre des données intermédiaires dans une plage de fréquences intermédiaire entre les première et seconde plages de fréquences.

6. Appareil (700) de la revendication 5, ledit nombre de points de données dans les données intermédiaires des données numériques de domaine fréquentiel converties dans le sens descendant étant inférieur au nombre de points de données des premières données numériques de domaine fréquentiel en dehors des première et seconde parties de celles-ci.

7. Appareil (700) de la revendication 5 ou de la revendication 6, un rapport d'un nombre de points de données des premières données numériques de domaine fréquentiel dans la combinaison des première et seconde parties de celles-ci sur un nombre de points de données des premières données numériques de domaine fréquentiel en dehors des première et seconde parties de celles-ci étant inférieur à un rapport d'un nombre de points de données dans la combinaison des premières et secondes données des données numériques de domaine fréquentiel converties dans le sens descendant sur un nombre de points de données des données intermédiaires des données numériques de domaine fréquentiel converties dans le sens descendant.

8. Appareil (700) de l'une quelconque des revendications 5 à 7, lesdites données intermédiaires comprenant ou étant constituées de points de données de valeur nulle.

9. Appareil (700) de l'une quelconque des revendications 2 à 8, un rapport d'un nombre de points de données des premières données numériques de domaine fréquentiel dans la combinaison des première et seconde parties de celles-ci sur un nombre total de points de données des premières données numériques de domaine fréquentiel étant inférieur à un rapport d'un nombre de points de données dans la combinaison des premières et secondes données des données numériques de domaine fréquentiel converties dans le sens descendant sur un nombre total de points de données des données numériques de domaine fréquentiel converties dans le sens descendant.

10. Appareil (700) de l'une quelconque des revendications 2 à 9, ladite bande de fréquences cible étant constituée des première et seconde parties de celle-ci.

11. Appareil (700) d'une quelconque revendication précédente, ledit appareil (700) étant destiné à des communications de fond de trou.

12. Procédé de conversion descendante d'un signal de communication reçu modulé en fréquence, le procédé est mis en œuvre par un appareil et comprenant :
l'obtention (802) de premières données numériques de domaine fréquentiel sur la base du signal de communication reçu modulé en fréquence ;
le traitement (804) des premières données numériques de domaine fréquentiel dans le domaine fréquentiel pour fournir des données numériques de domaine fréquentiel converties dans le sens descendant, le traitement comprenant le décalage de fréquence de données sur la base d'au moins une partie des premières données numériques de domaine fréquentiel, les données numériques de domaine fréquentiel converties dans le sens descendant possédant moins de points de données que les premières données numériques de domaine fréquentiel ; et
la conversion (806) des données numériques de domaine fréquentiel converties dans le sens descendant dans le domaine temporel ;
ledit traitement comprenant la réduction d'une quantité de points de données d'une première quantité de points de données dans les premières données numériques de domaine fréquentiel à une seconde quantité de points de données dans les données numériques de domaine fréquentiel converties dans le sens descendant, la seconde quantité étant inférieure à la première quantité.

13. Noeud de communication comprenant un appareil (700) de l'une quelconque des revendications 1 à 11.

14. Produit-programme informatique comprenant des instructions de programme informatique destinées à amener le montage de circuits de traitement à fonctionner conformément au montage de circuits de traitement (140) de l'appareil (700) selon l'une quelconque des revendications 1 à 11.

15. Support lisible par ordinateur non transitoire comprenant des instructions exécutables pour amener le montage de circuits de traitement à fonctionner conformément au montage de circuits de traitement (140) de l'appareil (700) selon l'une quelconque des revendications 1 à 11.
